# EUROPEAN PATENT APPLICATION

(11) **EP 4 579 723 A1**
(43) Date of publication of application: **02.07.2025**
(21) Application number: 23220695.3
(22) Date of filing: 29.12.2023
(51) Int. Cl.: H01L 21/68, H01L 21/67

(54) **APPARATUS AND METHOD FOR MULTI-STAGE DIE BONDING**

(71) Applicant: ASML Netherlands B.V., 5500 AH Veldhoven (NL)
(72) Inventor: DE JAGER, Pieter, Willem, Herman, 5500 AH Veldhoven (NL); SCHOUTEN, Christine, Henriette, 5500 AH Veldhoven (NL); DOLK, Victor, Sebastiaan, 5500 AH Veldhoven (NL); WAHBEH, Lotfi, 5500 AH Veldhoven (NL); ASSENDELFT, Joep, 5500 AH Veldhoven (NL); BUSTRAAN, Krijn, Frederik, 5500 AH Veldhoven (NL); SAHIN, Buket, 5500 AH Veldhoven (NL); ALLELEIJN, Joep, Hanni, Hub, Maria, 5500 AH Veldhoven (NL); BROERS, Sander, Christiaan, 5500 AH Veldhoven (NL); VENUGOPALAN, Syam Parayil, 5500 AH Veldhoven (NL)
(74) Representative: ASML Netherlands B.V.

(57) **Abstract**

An apparatus and method of operating said apparatus, the apparatus comprising at least a first stage configured to support one or more donor dies and a second stage configured to support one or more target dies, the apparatus configured to measure a position of the one or more donor dies and configured to measure a position of the one or more target dies and to provide relative movement between at least one of the one or more donor dies and a corresponding one of the one or more target dies for die bonding by movement of the first stage and/or the second stage.

## Description

### TECHNICAL FIELD

The present disclosure relates generally to a method and tool for multi-stage die bonding.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die-where these specific portions may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another. In the context of semiconductor manufacture, improvements in die placement and alignment (e.g., improvements in heterogeneous integration) lead to improvements in IC manufacturing and integration abilities.

### SUMMARY

According to an embodiment, there is provided a system for die bonding, the system comprising:
a first stage configured to support one or more donor dies;
a second stage configured to support one or more target dies;
a measurement system configured to measure a position of the one or more donor dies and configured to measure a position of the one or more target dies; and
a positioner system configured to provide relative movement between at least one of the one or more donor dies and a corresponding one of the one or more target dies for die bonding by movement of the first stage and/or the second stage.

According to an embodiment, there is provided a high-volume manufacturing tool.

According to an embodiment, there is provided a method for die bonding, the method comprising:
causing, by a processor system, a first stage to transport one or more donor dies to a measurement system, the measurement system configured to measure a position of the one or more donor dies;
causing, by the processor system, a second stage to transport one or more target dies to the measurement system, the measurement system further configured to measure a position of the one or more target dies; and
based on the measured position of the one or more donor dies and the measured position of the one or more target dies, aligning one or more of the one or more donor dies with corresponding one or more of the one or more target dies for die bonding.

According to another embodiment, one or more non-transitory, machine-readable medium is provided having instructions thereon, the instructions when executed by a processor being configured to perform a method as described herein.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to one or more embodiments.
Figures 2A-2F are schematic diagrams illustrating an example method of die placement, according to one or more embodiments.
Figures 3A-3J are schematic diagrams illustrating portions of an example apparatus for die bonding, according to one or more embodiments.
Figures 4A-4AH are schematic diagrams illustrating operations of an example multi-stage apparatus for die bonding, according to one or more embodiments.
Figure 5 is a flowchart which illustrates an exemplary method of die placement, according to one or more embodiments.
Figure 6 is a block diagram of an example computer system, according to one or more embodiments of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or". "Each", "every", "all", "corresponding", "individual" and other relational terms encompass substantially "each", "every", "all", etc., including cases in which each, every, all, corresponding, individual, etc. may include relationship which are not one-to-one, or do not include every possible item. For example, every may exclude items, such as items determined to be defective during testing. Each may exclude items, such as edge items, which are not used. All may exclude items, such as excess items. Corresponding may not require that items correspond in an exactly one to one manner. For example, a first item may correspond to two of a second item or vice versa. In some cases, individual may refer to multiple of an item, such as each item A has individual item B, where an item A may have two of an item B.

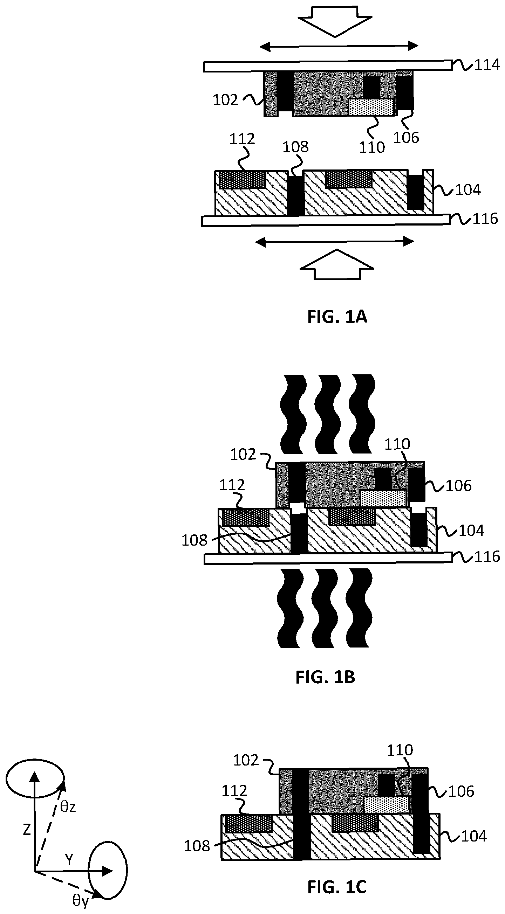

Reference is now made to Figures 1A-1D, which are schematic diagrams illustrating an exemplary die bonding method consistent with embodiments of the present disclosure. The exemplary die bonding method is depicted in relation to a reference set of axes, which are consistent through the schematic illustrations. The reference axes are provided for ease of description only and are not to be taken as limiting. Included methods and apparatuses may instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The reference set of axes is chosen such that the fabrication plane of the die (i.e., a substrate surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative descriptions, and that elements described as corresponding to a "donor" can instead correspond to a "target" and vice versa. A target die may also or instead be called an acceptor die. Further, while just one donor die and target die are depicted in Figure 1A, it will be appreciated that there may be multiple such die and that multiple donor die may be essentially simultaneously bonded with multiple target die, e.g., where, for example, multiple die are still part of (all or part) a substrate in or on which they are formed.

The donor die 102 may have one or more electrically active areas 106, such as on an alignment face of the donor die 102. The one or more electrically active areas 106 may be conductive, such as metal. The one or more electrically active areas 106 may correspond to one or more vias (e.g., one or more through silicon vias (TSVs)), one or more electrical contact lines, one or more contact pads, one or more packaging pads, or other one or more electrically conductive areas. The donor die 102 may have one or more electrically inert areas (for example, an electrically insulating area) outside of the one or more electrically active areas 106, such as on the alignment face of the donor die 102. The one or more electrically active areas 106 may be recessed (as shown) with respect to one or more other surfaces of the donor die 102. The one or more electrically active areas 106 may correspond to one or more contacts (e.g., to source, to drain, to gate, etc.) to one or more electrical devices within the donor die 102 (not shown). The target die 104, likewise, may have one or more electrically active areas 108, which may have one or more similar properties to the one or more electrically active areas 106.

The donor die 102 may also or instead have one or more doped areas 110, such as on an alignment face of the donor die 102, recessed below the alignment face of the donor die 102, etc. While the term "doped" is used, it should be understood that the one or more doped areas 110 may be any areas which, through the course of fabrication, come to have one or more different electrical characteristics than the bulk of the substrate (e.g., silicon wafer). The one or more doped areas 110 may correspond to source, drain, gate, ground, or other areas of a circuit which is doped or otherwise altered (e.g., through implantation, oxide growth, thin film deposition, etc.) to have a different electrical characteristic than the bulk of the substrate. The one or more doped areas 110 may include one or more conductive layers (e.g., one or more highly doped or electrically conductive layers) and/or one or more insulative layers (e.g., one or more oxide layers). The donor die 102 may have one or more undoped areas (for example, an area where the substrate retains the characteristic of the bulk substrate) outside of the one or more doped areas 110, such as on the alignment face of the donor die 102. The one or more doped areas 110 may be recessed, buried, coplanar (as shown), etc. with respect to one or more other surfaces of the donor die 102. The one or more doped areas 110 may correspond to one or more regions (e.g., to one or more source regions, one or more drain regions, one or more gate regions, one or more dielectric regions, etc.) of one or more electrical devices within the donor die 102 or one or more regions which may form one or more electrical devices across both the donor die 102 and the acceptor die 104 once those die are bonded. The target die 104, likewise, may have one or more doped areas 112, which may have one or more similar properties to the one or more doped areas 110.

As shown in Figures 1A and 1B, the exemplary die bonding method may involve alignment of at least one of the electrically active areas 106 and/or doped areas 110 of the donor die 102 with at least one of the electrically active areas 108 and/or doped areas 112 of the target die 104. The exemplary die bonding method may involve bringing the donor die 102 into contact with the target die 104 while maintaining alignment between, e.g., one or more electrically active areas 106 and one or more electrically active areas 108 so that the one or more electrically active areas 106 and the one or more electrically active areas 108 may be joined for cross-die electrical communication. The exemplary die bonding method may involve aligning one or more doped areas 110 of the donor die 102 with one or more doped areas 112 of the target die 104. Aligning may encompass bringing into contact, aligning one or more edges of various regions, having overlap, having non-overlap, or any other appropriate alignment scheme. The exemplary die bonding method may involve applying or maintaining pressure between the donor die 102 and the target die 104, while bonding occurs between the donor die 102 and the target die 104. The donor die 102 may be supported by a carrier structure 114, which may be a substrate which is transparent to a range of radiation (e.g., infrared radiation, a portion of the optical spectrum, etc.). The target die 104 may likewise be supported by a carrier structure 116, which may or may not be transparent to a range of radiation. Alternatively, the target die 104 (possibly together with the carrier structure) may be part of an undiced or partially diced target wafer. The alignment may be complicated by the multiple layers of the donor die 102 or the multiple layers of the target die 104, which may be optically opaque.

Figures 1A and 1B depict a cross-sectional view of portions of the exemplary die bonding method showing relative positioning between the donor die 102 and the target die 104. As shown in Figure 1A, the donor die 102 and the target die 104 may be brought together along the z-axis, while the position of the donor die 102 or the target die 104 may be adjusted in the x-y plane (e.g., perpendicular to the z-axis of approach), such as to improve alignment between the donor die 102 and the target die 104. As shown in Figure 1B, alignment can be achieved between, e.g., one or more electrically active areas 106 and one or more electrically active areas 108 and/or between one or more doped areas 110 of the donor die 102 with one or more doped areas 112 of the target die 104.

Once aligned, the donor die 102 and the target die 104 are bonded together. In an embodiment, the bonding is a direct or fusion bonding (e.g., involving van der Waals forces). In an embodiment, the bonding is an intermolecular bonding, e.g., van der Waals bonding. In an embodiment, the bonding may include covalent, ionic, or metallic (e.g., chemical) bonding. In an embodiment, the bonding is aided by a material (e.g., a suitable bonding or adhesive material) applied to an alignment surface of the donor die 102 and/or target die 104 or provided to a gap between the donor die 102 and the target die 104 (e.g., in the form of gas or liquid). In some embodiments, physical contact between the donor die 102 and the target die 104 may include bonding, such as through a bonding wavefront generated by contact (or atomic level proximity), such as of a surface prepared for hydrogen bonding.

As shown in Figure 1B, the donor die 102 and the target die 104 may be annealed after contact as depicted by the wavy lines (while wavy lines are shown here at both the donor die 102 and the target die 104, the annealing agent need not be provided at both the donor die 102 and the target die 102 nor needs to be applied in the direction(s) shown). Annealing may be or include heat annealing, electrical annealing, electrostatic processes, etc. In some embodiments, annealing may include annealing of in-plane (or prominent) regions that are bonded and/or annealing of one or more recessed areas which may increase the volume of fill in a recess area (such as through thermal expansion, capillary force, etc.) and may cause physical contact and bonding of areas previously not in contact. As shown in Figure 1C, annealing may cause physical or chemical changes, such as in the one or more electrically active areas 106 of the donor die 102 or in the one or more electrically active areas 108 of the target die 104, which may cause or improve physical contact or electrical contact between an electrically active area 106 and an electrically active area 108. Annealing may therefore produce or enhance electrical connectivity between elements of the donor die 102 and the target die 104 (e.g., integration). This electrical connectivity may occur even if an electrically active area 106 and an electrically active area 108 differ-for example, have different recessed depths, are made up of different materials, have different dimensions, etc. In an embodiment, the prior bonding described with respect to Figure 1A may be temporary during one or more portions of the annealing process, wherein the annealing process forms tight connections between donor die 102 and the target die 104. In an embodiment, the annealing may occur in the system where the bonding occurs. In an embodiment, the annealing may occur in a separate system from the system in which the bonding occurs, e.g., the donor and target dies are transported out of the bonding system into an annealing system which can include one or more heating elements (e.g., one or more electrical heating elements, one or more elements to provide radiation heating, etc.) to provide the heat for the annealing.

Once the donor die 102 and the target die 104 are bonded, the carrier structure 114 may be removed as shown in Figure 1B. Additionally or alternatively, the carrier structure 116 may be removed then as well. Alternatively, once the donor die 102 and the target die 104 are annealed, the carrier structure 116 may be removed as shown in Figure 1C. Additionally or alternatively, the carrier structure 114 may be removed then as well.

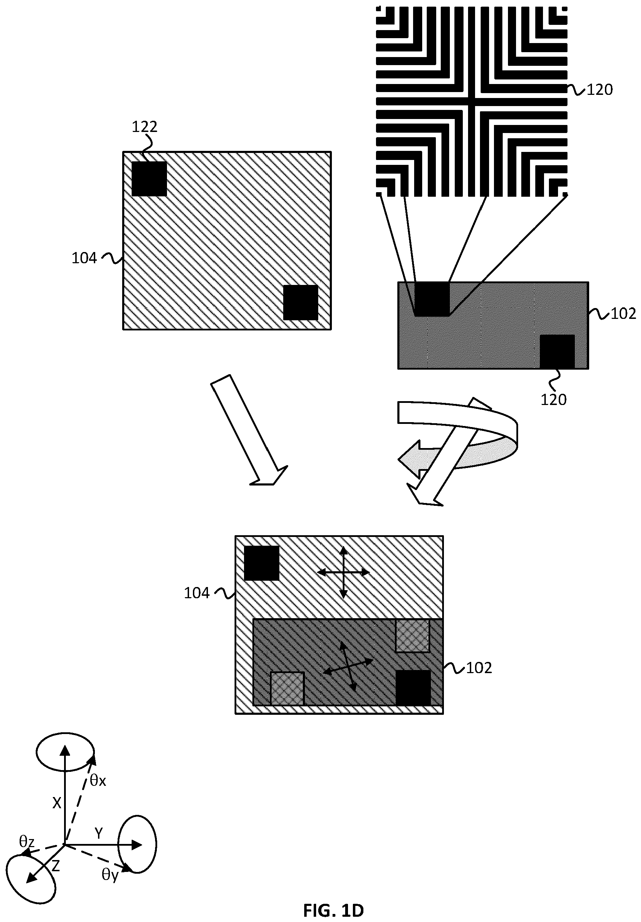

Figure 1D depicts a plan view of an example die bonding method according to this disclosure. As shown in Figure 1D, the donor die 102 and the target die 104 may have one or more alignment marks along the x-y plane to facilitate alignment of the die as a whole. Alignment marks in the x-y plane of a die (e.g., one or more alignment marks 120 on the donor die 102 or one or more alignment marks 122 on the target die 104) may reduce the area available for circuitry. One or more alignment marks may be placed in a waste area, such as an area between chips, which may then be destroyed (e.g., removed) during dicing. Dicing herein refers to mechanical separation of areas of a substrate (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the substrate volume when separating die. Alignment marks may be additively or substractively fabricated, such as by etching or deposition in the z-direction. Alignment marks 120 and 122 may be the same or different. Alignment marks 120 and 122 may be a multi-directional alignment mark, i.e., capable of determining alignment in more than one direction, such as a bi-direction alignment mark, an example of which is shown as mark 120 in Figure 1D. The alignment mark 120 and/or alignment mark 122 may be a fine alignment mark, such as for alignment in the µm scale. The alignment mark 120 may be located on the donor die 102 while the target die 104 may have an alignment mark 122 located in a waste area, or vice versa. Alternatively or additionally, one or more electrically active and/or doped areas of the donor die 102 or one or more electrically active and/or doped areas of the target die 104 (not shown in Figure 1D) or other surface features may function as a reference for alignment (e.g., an alignment mark) of the donor die 102 and/or the target die 104.

The donor die 102 and the target die 104 may be aligned in up to three dimensions before or during contact between the donor die 102 and the target die 104. For example, the donor die 102 or the target die 104 may be positioned in the x-y plane as the donor die 102 in the target die 104 are contacted. The donor die 102 or the target die 104 may be positioned by operation of a die actuator or other die-scale elements, such as by piezoelectric stepper elements, or by operation of a chuck or other carrier structure-scale elements, such as by a motor or other actuator. The position of the donor die 102 or the target die 104 may be adjusted with respect to up to six degrees of freedom. For example, given an origin point at a central part of the donor die 102, the donor die 102 may be positioned by movement along the X axis (e.g., in a positive or negative X direction), along the y-axis (e.g. in a positive or negative Y direction), along the z-axis (e.g., in a positive or negative Z direction). The donor die 102 may also be positioned rotationally with respect to each of those axes-e.g., rotated with respect to the x-axis, rotated with respect to the y-axis, rotated with respect to the z-axis. That is, the donor die 102 may be positioned by free movement in space accounted for by six different types of movement (where the movements listed above are provided as examples but where the movements may be described by other axes). Of course, the target die 104 may be positioned alone or combined with positioning of the donor die 102. Positioning or adjustment of position herein, unless the context otherwise requires, includes displacement, rotation or any combination thereof.

In some embodiments, the donor die 102 and the target die 104 may be measured with respect to a reference plane or structure (e.g., the X-Y plane), including with respect to the same reference plane or structure, but the donor die 102 or the target die 104 may be flipped (before or after measurement) so that the fabrication surface of the donor die 102 and the fabrication surface of the target die 104 may be bonded (see, e.g., the bottom diagram of Figure 1D). The one or more alignment marks (e.g., the alignment marks 120 and 122) may be on the fabrication surface of the donor die 102 and the target die 104, respectively. Once the donor die 102 or the target die 104 is flipped, one or more alignment mark may be rendered invisible (such as due to opacity of a die) to an alignment measurement tool. The alignment of the flipped die may therefore be performed based on previously measured positions of the die (e.g., of the one or more alignment marks of the die) with respect to a structure, such as the donor die 102 with respect to the carrier structure 114 or such as the target die 104 with respect to the carrier structure 116.

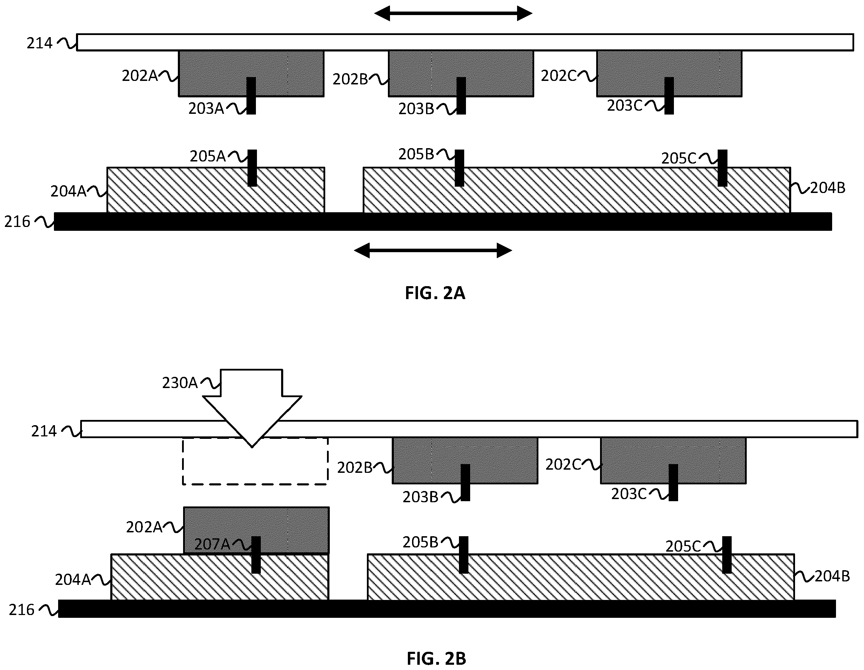

Figures 2A-2F are schematic diagrams illustrating an example method of die placement. Figures 2A-2F are described with reference to "donor die" (and "donor substrate" containing multiple "donor die") and "target die" (and "target substrate" containing multiple "target die"), which are relative descriptors and donor die may instead be target die and vice versa. Figures 2A-2F are described with respect to donor die and target die, but may instead be a donor substrate or target substrate, where a "substrate" may contain multiple "die", including un-diced (e.g., unseparated) die in the form of all or part of a semiconductor wafer. Figure 2A-2F are cross-sectional views of die placement of donor dies (e.g., donor die 202A, 202B, 202C) on target dies (e.g., target die 204A and target die 204B). In some embodiments, multiple steps which are depicted as occurring substantially simultaneously in Figures 2A-2F may be performed sequentially. In some embodiments, multiple steps which are depicted as occurring sequentially in Figures 2A-2F may be performed substantially simultaneously. In some embodiments, multiple donor dies may be aligned or placed on their respective target dies substantially simultaneously, including donor dies which are proximate (including adjacent) or distant (e.g., non-adjacent but within the same target substrate). In some embodiments, steps may be performed in a different order.

Figure 2A is a cross-sectional view of donor dies 202A-202C which are to be placed on target dies 204A-204B. The donor dies 202A-202C are supported by a carrier structure 214. The donor dies 202A-202C may be adhered to the carrier structure 214 in any appropriate manner, such as by vacuum adhesion, electrostatic adhesion, intermolecular adhesion, mechanical interlocking, surface reaction, static friction, gravitational force, etc. The donor dies 202A-202C may be adhered to the carrier structure 214 by use of an adhesive (e.g., glue), such as an organic, polymer glue. The carrier structure 214 may be a transparent substrate, such as glass, sapphire, polymer, etc. substrate. The donor dies 202A-202C may be placed on the carrier structure 214 by any appropriate method, such as by a pick and place tool. The carrier structure 214 may be supported by a chuck or any other appropriate support structure.

The target dies 204A-204B are supported by a support structure 216. In an embodiment, the target dies 204A-204B may be part of an undiced or partially diced target wafer. The target dies 204A-204B may be adhered to the support structure 216 in any appropriate manner, such as by vacuum adhesion, electrostatic adhesion, intermolecular adhesion, mechanical interlocking, surface reaction, static friction, gravitational force, etc. The target dies 204A-204B may be adhered to the support structure 216 by use of an adhesive (e.g., glue), such as an organic, polymer glue. In an embodiment, where, for example, the target dies 204A-204B are diced die, the support structure may be a carrier structure (e.g., like carrier structure 214) and may be a transparent substrate, such as glass, sapphire, polymer, etc. substrate. The target dies 204A-204B may be placed on the support structure 216 by any appropriate method, such as by a pick and place tool. The support structure 216 may be, or may be supported by, a chuck or any other appropriate structure.

The donor dies 202A-202C and the target dies 204A-204B may be aligned with one another at alignment points 203A and 205A (for donor die 202A and target die 204A), alignment points 203B and 205B (for donor die 202B and target die 204B), and alignment points 203C and 205C (for donor die 202C and target die 204B). In some embodiments, multiple donor die may be placed on a single target die, and vice versa, such as depending on integration goals. The alignment points 203A-203C are depicted for the donor dies 202A-202C, while the alignment points 205A-205C are depicted for the target dies 204A-204B. These alignment points are provided for ease of description only and need not be physical features. There may be multiple alignment points per die. The alignment points may be alignment marks (for example, the alignment marks of Figure 1D), die edges, die corners, other features on edges or surfaces of die. The alignment points may be used to align donor and target die, such as by measurement of the locations of various alignment points and then adjustment of the position of the donor and/or target die, such as by movement of a carrier structure supporting the die, to align an alignment point of the donor die with an alignment point of the target die (or vice versa). The alignment points may be aligned directly to one another (e.g., as depicted in Figures 2A-2F). In some embodiments, the alignment points may be aligned relative to one another (e.g., in a predetermined relationship, such as separated by a vector), such as depicted in the bottom of Figure 1D, where the alignment marks are non-overlapping.

In Figure 2A, the carrier structure 214 (and/or the support structure 216) may be positioned, such as in the X-Y plane, in order to align the alignment point 203A of the donor die 202A with the alignment point 205A of the target die 204A.

In Figure 2B, the donor die 202A may be released from the carrier structure 214 by any appropriate mechanism, such as release mechanism 230A. The donor die 202A meets the target die 204A at alignment point 207A. The release of the donor die 202A may be facilitated by gravity, by electrostatic forces, by physical forces, etc. The alignment of the donor die 202A and the target die 204A at the alignment point 207A (which represents a combination of the alignment point 203A and the alignment point 205A of Figure 2A) may be assisted by any appropriate alignment mechanism, including self-alignment (e.g., attraction of one area of the donor die 202A to a corresponding area of the target die 204A). In an embodiment, the release occurs while donor die 202A is in (at least partial) contact with target die 204A. In an embodiment, the release occurs before donor die 202A is in contact with the target die 204A.

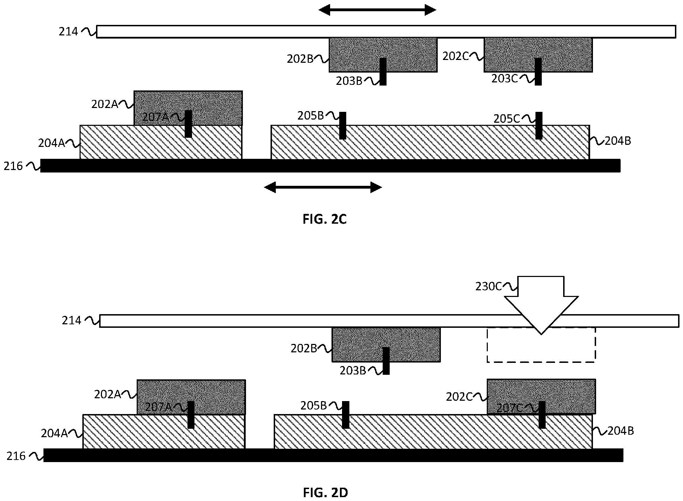

In Figure 2C, the carrier structure 214 and alternately or additionally the support structure 216 may be moved to bring another donor die (e.g., the donor die 202C) into alignment with another target die (e.g., the target die 204B). The alignment of alignment point 203C (of donor die 202C) and alignment point 205C (of target die 204B) may be based on measurements of the relative positions of the alignment points (such as using an alignment mark or feature on a die or carrier structure, using a position of an alignment point on another donor or target die, etc.). The alignment of alignment point 203C (of donor die 202C) and alignment point 205C (of target die 204B) may be based on one or more substantially simultaneous measurement of the relative positions of an alignment point, such as using an alignment mark or feature of a die or carrier structure, using an alignment target or feature of another donor or target die, etc. Although alignment of only one donor die (e.g., the donor die 202C) and target die (e.g., the target die 204B) is depicted, alignment of one or more sets of donor and target dies may occur substantially simultaneously, such as if for a given relative position of the carrier structure 214 and the support structure 216 the alignment points of multiple donor dies are aligned with the alignment points of multiple target dies. However, the ability to place multiple donor dies substantially simultaneously may depend on the placement of the donor dies on the carrier structure 214 and the ability of the release mechanism to release multiple donor dies.

In Figure 2D, the donor die 202C may be released from the carrier structure 214 by any appropriate mechanism, such as release mechanism 230C. The donor die 202C meets the target die 204B at alignment point 207C. The release of the donor die 202C may be facilitated by gravity, by electrostatic forces, by physical forces, etc. The alignment of the donor die 202C and the target die 204B at the alignment point 207C (which represents a combination of the alignment point 203C and the alignment point 205C of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

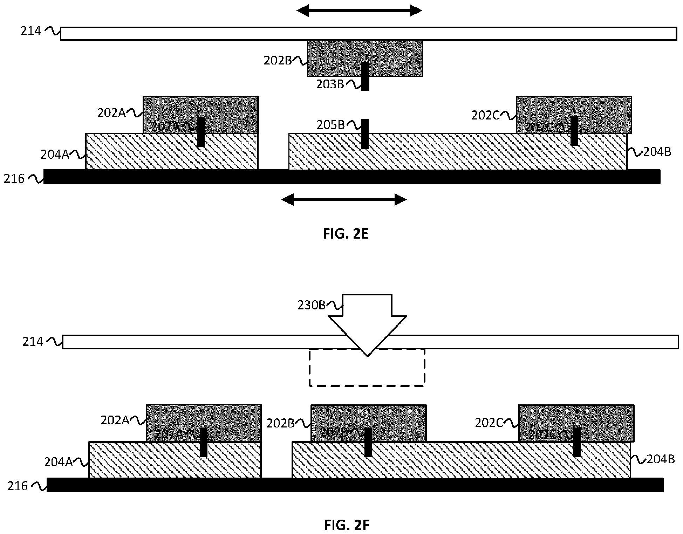

In Figure 2E, the carrier structure 214 and alternately or additionally the support structure 216 may be moved to bring another donor die (e.g., the donor die 202B) into alignment with another target die (e.g., the target die 204B). The alignment of alignment point 203B (of donor die 202B) and alignment point 205B (of target die 204B) may be based on previous measurements of the relative positions of the alignment points (such as using an alignment mark on a die or carrier structure, using an alignment point on another donor or target die, etc.). The alignment of alignment point 203B (of donor die 202B) and alignment point 205B (of target die 204B) may be based on one or more substantially simultaneous measurement of the relative positions of an alignment point, such as using an alignment mark or feature of a die or carrier structure, using an alignment target or feature of another donor or target die, etc. As depicted, the donor die 202B and the donor die 202C are aligned to the same target die (e.g., the target die 204B). In some embodiments, the donor die are placed on the target die in a substantially one-to-one relationship (e.g., as depicted for the donor die 202A and the target die 204A). In some embodiments, multiple donor die (or target die) may be placed on the same target die (or donor die). In some embodiments, multiple donor die (or target die) may be placed on un-diced (e.g., unseparated) target die (or donor die), such as all or part of a substrate containing target die (or donor die). In some embodiments, a donor die may be placed on a target die that has multiple die, including stacked (e.g., bonded) die, such as in a three layer die bonding stack.

In Figure 2F, the donor die 202B may be released from the carrier structure 214 by any appropriate mechanism, such as release mechanism 230B. The donor die 202B meets the target die 204B at alignment point 207B. The release of the donor die 202B may be facilitated by gravity, by electrostatic forces, by physical forces, etc. The alignment of the donor die 202B and the target die 204B at the alignment point 207B (which represents a combination of the alignment point 203B and the alignment point 205B of Figure 2A) may be assisted by any appropriate alignment mechanism, including self-alignment. In an embodiment, the release occurs while donor die 202B is in (at least partial) contact with target die 204B. In an embodiment, the release occurs before donor die 202B is in contact with the target die 204B.

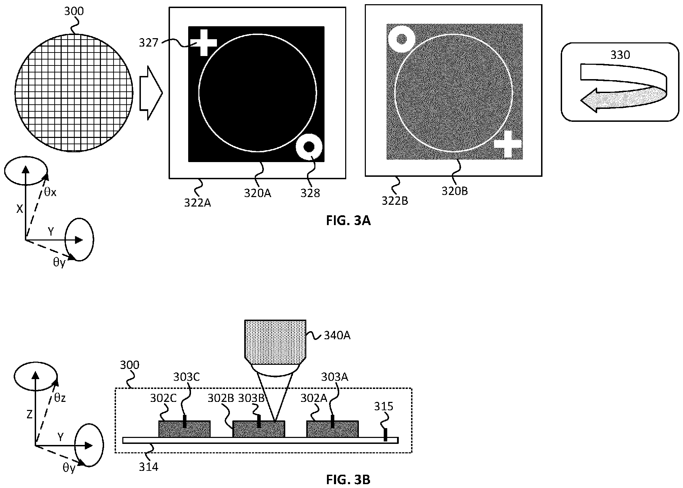

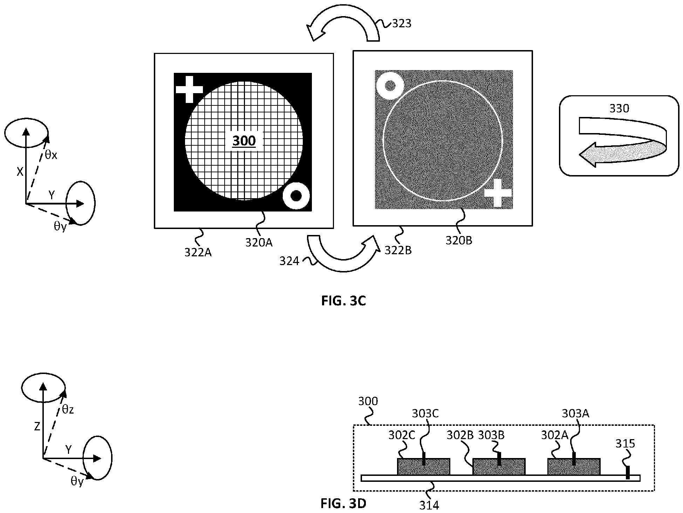

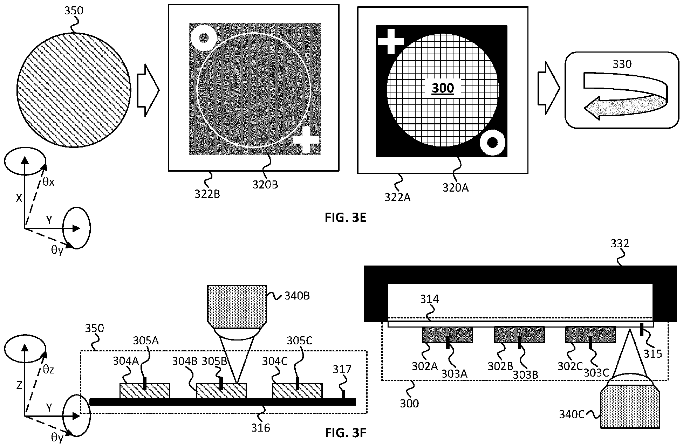

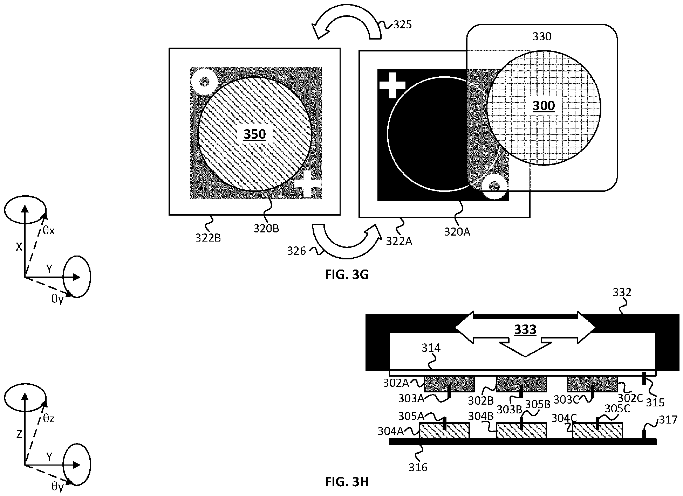

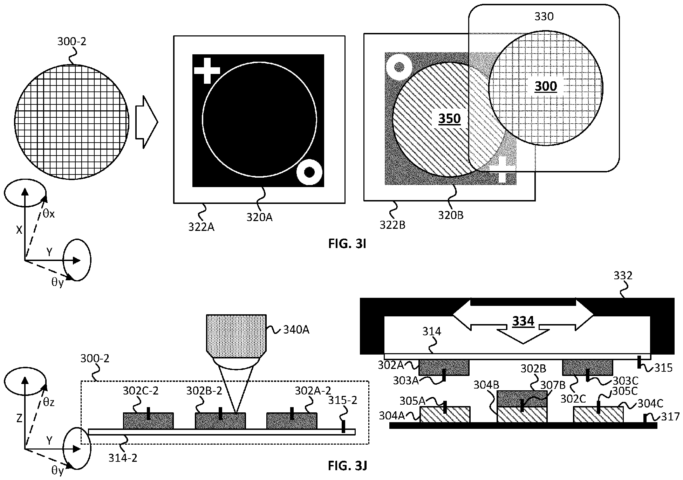

Figures 3A-3J are schematic diagrams illustrating portions of an example apparatus for die bonding. Figures 3A-3J are described with reference to "donor die" and "target die", which are relative descriptors as used herein and donor die may instead be target die and vice versa. Each of Figures 3A, 3C, 3E, 3G, and 3I is a plane view of an apparatus during placement of donor die on the target die. Each of Figures 3B, 3D, 3F, 3H, and 3J is a cross-sectional view of the apparatus during placement of donor die on the target die. The views of the apparatus in various figures represent different operations of the apparatus, but operations depicted as occurring in different figures may occur at different times or may instead be performed simultaneously and operations depicted as occurring in the same figure may instead be performed individually or at different times. A donor substrate 300 and a target substrate 350 are depicted as circular, but may instead be any appropriate shape, including rectangular, square, etc. The donor substrate 300 (and target substrate 350) may be the substrate in or on which the donor die (target die) have been formed. The donor substrate 300 (target substrate 350) may be a "reconstructed wafer", in which donor die (target die) (or other disparate portions of a semiconductor substrate) are arranged or supported on a carrier structure, e.g., to be in position suitable for die bonding. So, the donor substrate 300 (target substrate 350) may be a carrier structure and donor die (target die), where the donor die (target die) may be held (e.g., adhered) to the carrier structure by any appropriate method, such as by gravitational force, by adhesive (e.g., organic, polymer adhesive), by electrostatic forces, etc. The donor substrate 300 (target substrate 350) may contain previously tested donor die (target die), such as donor die (target die) that passed a failure analysis or other post fabrication testing. The donor substrate 300 (target substrate 350) may contain donor die (target die) from the same or different semiconductor substrates (e.g., fabrication substrates), including donor die (target die) of different types, different dimensions, etc. The donor substrate 300 (target substrate 350) may have donor die (target die) placed on the donor substrate 300 (target substrate 350) by any appropriate method, such as a pick and place tool. The donor substrate 300 (target substrate 350) may be supported, such as by a carrier structure, vacuum chuck, electrostatic chuck, etc., by either a top side (e.g., fabrication face) or backside (e.g., bulk substrate or carrier structure face) or by different faces at various points. The donor substrate 300 or donor die (target substrate 350 or target die) may have fabricated devices on multiple faces, such as through silicon vias (TSVs), contact pads, etc., such that both a top side and backside are fabrication faces.

In Figure 3A, the donor substrate 300 may be placed on a substrate chuck 320A. The substrate chuck 320A may be an appropriate substrate chuck, such as to support the donor substrate 300 in the form of a semiconductor substrate or a carrier structure of the donor substrate 300. The substrate chuck 320A may be supported by a support structure 322A. The support structure 322A may be a moveable support structure, which may move in the X-Y plane, such as from a first position where the substrate chuck 320A receives the donor substrate 300 to a second position where the donor substrate 300 may be subjected to metrology. The substrate chuck 320A may contain (e.g., support) one or more die actuators or other mechanical or electrical actuators which may move a donor die or the donor substrate 300 in one or more dimension, including in the X-Y plane, in the Z-direction, rotationally, etc. The substrate chuck 320A may have one or more alignment marks, such as to allow a camera or other measurement system to track the position of the substrate chuck 320A. The substrate chuck 320A may have multiple sets of alignment marks, such as coarse alignment marks and/or fine alignment marks. The substrate chuck 320A may move, such as by action of the support structure 322A, from one position to another, in free space, etc. The support structure 322A may be configured to move in multiple directions and in multiple scales (e.g., in a coarse step and a fine step), such as by multiple motors or steppers. The support structure 322A may be activated by a controller of the example apparatus-where the controller of the example apparatus (not depicted) may also control the placement of the donor substrate 300 on the substrate chuck 320A and other operations described herein.

The substrate chuck 320A may have a measurement point (or alignment point), such as identified by a cruciform measurement mark 327 and a round zero measurement mark 328, which are provided merely as examples and where any appropriate zero measurement mark may be used. The measurement point may be used to place the donor substrate 300 on the substrate chuck 320A, such as during movement of the substrate onto the chuck (for example, by insertion of the donor substrate by a substrate handler). The measurement point may be used to measure relative positions of the donor die of the donor substrate 300 once the donor substrate 300 is placed on the substrate chuck 320A. The placement of the donor die may be measured, such as with up to nm precision, with respect to the measurement point. The measurement of the position of the donor die after their placement may be obtained from any appropriate measurement system, such as optical microscopy, reflectometry, etc.

Figure 3A also depicts a further substrate chuck 320B on a support structure 322B. The substrate chuck 320B may be any appropriate substrate chuck, such as substantially identical to the substrate chuck 320A. The support structure 322B may be any appropriate support structure, such as substantially identical to the support structure 322A. In some embodiments, the substrate chuck 320B and the substrate chuck 320A may be substantially indistinguishable. In some embodiments, the support structure 322B and the support structure 322A may be substantially indistinguishable. Although two substrate chucks and two support structures are depicted, in some embodiments more or less substrate chucks and support structures may be present in the apparatus. Operations depicted as performed by the substrate chuck 320B (substrate chuck 320A) may instead or additionally be performed by any appropriate substrate chuck. Likewise, operations depicted as performed by the support structure 322B (support structure 322A) may instead or additionally be performed by any appropriate support structure.

Figure 3A also depicts flipper 330. The flipper 330 may be any appropriate apparatus which may flip a substrate (e.g., donor substrate 300), such as about the longitudinal axis or plane of the donor substrate 300 depicted in Figure 3A. The flipper 330 will be described in more detail in reference to Figures 3E and 3F.

In Figure 3B, a cross-sectional view of a donor substrate 300 is depicted. The donor substrate 300 comprises a carrier structure 314 which supports one or more donor die (e.g., donor die 302A-302C). The substrate may have one or more alignment points, such as alignment point 315, used to measure a relative position of the donor die 302A-302C with respect to the carrier structure. The donor die may have alignment points, such as alignment points 303A-303C for donor die 302A-302C, respectively. The alignment points are provided as schematic representations in these drawings for ease of description, and may be any appropriate alignment points, including alignment marks, fabricated features, edge features, etc., as previously described. While the donor substrate 300 is on a substrate chuck (e.g., the substrate chuck 320A of Figure 3A), the positions of the donor die (e.g., the donor die 302A-302C) are measured, such as by metrology tool 340A. The positions may be measured as absolute positions, relative positions, positions relative to other die, positions relative to an alignment point of the substrate, etc. The measured positions may be stored by a controller of the apparatus, such as for later positioning of the donor substrate 300. The metrology tool 340A may be a camera, including a still camera, a video camera, etc. The metrology tool 340A may be any appropriate tool for measurement of a position of a donor die, measurement of a position of an alignment point of the donor die, measurement of a position of alignment mark of the donor die, etc.

In Figure 3C, the donor substrate 300 is supported by the substrate chuck 320A, which is supported by the support structure 322A. Once the position of the donor dies are measured, the substrate chuck 320A may be moved, such as out of the measurement position. The support structure 322A may move (e.g., along direction 324) to the position of the support structure 322B, while the support structure 322B may move (e.g., along direction 323) to the position of the support structure 322A. The positions are provided as examples, and the support structures may move to different positions. For example, in some embodiments, the support structure 322B may move to a loading position, such as to receive a target substrate (e.g., the target substrate 350). The substrate chuck 320A may then occupy another position in the apparatus (e.g., a bonding position, a flipping position, etc.). The position the substrate chuck 320A moves to after measurement of the positions of the donor die (e.g., after the measurement depicted in Figure 3B) may be configured to allow the flipper 330 to accept the donor substrate 300 from the substrate chuck 320A.

In Figure 3D, the movement of the donor substrate 300 to a position other than the measurement position of Figure 3B is depicted. The movement may correspond to the movement of the donor substrate 300 in the direction 324, such as by movement of the support structure 322A, of Figure 3C. This figure is provided to show continuity of the die bonding process in both plane and cross-sectional views, but may occur substantially simultaneously with the process depicted in Figure 3C or Figure 3E, where, as previously described, steps which are depicted as occurring separately, including sequentially, may be performed substantially simultaneously.

In Figure 3E, the target substrate 350 may be placed on a substrate chuck 320B. The substrate chuck 320B may be an appropriate substrate chuck, as previously described. The substrate chuck may be supported by a support structure 322B, which may be any appropriate support structure, as previously described.

In Figure 3E, the donor substrate 300 may be transferred to the flipper 330. The flipper 330 may accept (e.g., take) the donor substrate from the substrate chuck 320A, such as by use of edge clamps, vacuum clamps, finger prongs, etc. The flipper 330 may hold the donor substrate by one or more edges (e.g., one or more edges of the carrier structure 314) or one or more sides (for example, a backside of the carrier structure 314 which does not support the donor die). The flipper 330 may rotate the donor substrate 300 upside down (e.g., with respect to the direction of the gravitational force). The flipper 330 may hold the donor substrate 300 upside down (e.g., opposite to) with respect to the X-Y plane which it previously occupied-or in any other appropriate direction. The flipper 330 may hold the donor substrate 300 or place the donor substrate 300 into a support structure, such that the donor substrate 300 faces the plane of the target substrate 350. The flipper 330 may rotate or displace the donor substrate 300 in the X-Y plane, as well as displace or rotate the donor substrate 300 out of the X-Y plane. The flipper 330 may be any appropriate rotational or translational apparatus.

In Figure 3F, a cross-sectional view of the target substrate 350 is depicted. The target substrate 350 comprises a carrier structure 316 which supports one or more target dies (e.g., target die 304A-304C). The substrate may have one or more alignment points, such as alignment point 317. The target die may have alignment points, such as alignment points 305A-305C for target die 304A-304C, respectively. The alignment points are provided as schematic representations in these drawings for ease of description, and may be any appropriate alignment points, including alignment marks, fabricated features, edge features, etc., as previously described. While the target substrate 350 is on the substrate chuck (e.g., the substrate chuck 320B of Figure 3E), the positions of the one or more target dies (e.g., the target die 304A-304C) are measured, such as by metrology tool 340B. The metrology tool 340B may be the same as the metrology tool 340A used to measure the positions of the one or more donor dies (e.g., the donor die 302A-302C of Figure 3B) or a different metrology tool. The metrology tool 340B may measure a different number of positions, substantially different positions (e.g., arranged differently on the target substrate 300 than the positions on the donor substrate 300 as measured by the metrology tool 340A), different positions relative to dies (e.g., the donor die 302A-302C versus the target die 304A-304C), etc. than the metrology tool 340A. The positions may be measured as absolute positions, relative positions, positions relative to other die, positions relative to an alignment point of the substrate, etc. The measured positions may be stored by a controller of the apparatus, such as for later positioning of the target substrate 350. The metrology tool 340B may be a camera, including a still camera, a video camera, etc. The metrology tool 340B may be any appropriate tool for measurement of a position of a donor die, measurement of a position of an alignment point of the donor die, measurement of a position of alignment mark of the donor die, etc. The target substrate 350 may experience deformation due to the holding by a substrate chuck, etc. The metrology tool 340B may also enable determination of deformation of the target substrate by measuring locations. A controller may determine the deformation of the target substrate 350 based on those measured locations (e.g., from curve fitting, using a physical deformation model, etc.).

In Figure 3F, the donor substrate 300 is supported by a bonding support structure 332. The bonding support structure 332 may be part of the flipper 330 (of Figure 3E) or the donor substrate 300 may be placed into the bonding support structure 332 by the flipper 330. The bonding support structure 332 may hold the donor substrate 300 opposite to a plane of the target substrate 350. The bonding support structure 332 may hold the donor substrate by the carrier structure 314, including by one or more edges of the carrier structure 314. While in the bonding support structure 332, the position of the donor substrate 300 may be measured, such as by metrology tool 340C, to enable, for example, relative positioning between the donor substrate 300 and the target substrate 350. The metrology tool 340C may be any appropriate metrology tool. The metrology tool 340C may measure locations of the donor die (e.g., the donor die 302A-302C), locations of the alignment point 315, etc. The metrology tool 340C may measure significantly fewer locations than the metrology tool 340A or 340B, and the controller may determine the position of the target substrate 350 based on those fewer locations (e.g., from curve fitting, using physical deformation models, etc.). The controller may determine updated positions for the donor die (e.g., the donor die 302A-302C) based on a combination of the measured locations of the donor die 302A-302C (such as from Figure 3B) and the measured position of the donor substrate 300. The donor substrate 300 may experience deformation due to holding by a substrate chuck, the movement of the flipper 330, suspension from the bonding support structure 332, etc. The metrology tool 340C may also enable determination of deformation of the donor substrate by measuring locations. As noted above, the metrology tool 340C may measure significantly fewer locations than the metrology tools 340A and 340B, and the controller may determine the deformation of the donor substrate 300 based on those fewer locations (e.g., from curve fitting, using a physical deformation model, etc.) than those measured by the metrology tool 340A on the donor substrate 300 or by metrology tool 340B on the target substrate 350.

In Figure 3G, the target substrate 350 is supported by the substrate chuck 320B, which is supported by the support structure 322B. Once the position of the target dies are measured, the substrate chuck 320B may be moved, such as to align with the donor substrate 300 supported by the flipper (e.g., supported by the bonding support structure 332 of Figure 3F). The support structure 322B may move (e.g., along direction 326) to the position of the support structure 322A, while the support structure 322A may move (e.g., along direction 325) to the position of the support structure 322B. The positions are provided as examples, and the support structures may move to different positions. For example, in some embodiments, the support structure 322A may move to a loading position, such as to receive an additional target substrate (e.g., the target substrate 350). The substrate chuck 320B may then occupy another position in the apparatus (e.g., a bonding position). The position the substrate chuck 320B moves to after measurement of the positions of the target die (e.g., after the measurement depicted in Figure 3F) may be configured to place a donor die of the donor substrate 300 onto the target die of the target substrate 350. The substrate chuck 320B may be aligned with the donor substrate 300 in the flipper 330, which may be held above the plane of the substrate chuck 320B (as depicted in Figure 3G for a top down view in which the donor substrate 300 is at least partially above the plane of the substrate chuck 320B (e.g., obscuring the substrate chuck 320A).

In Figure 3H, the donor substrate 300 and the target substrate 350 are aligned. The donor substrate 300 may be aligned to the target substrate 350 by movement of the bonding support structure 332, such as in any of the directions or orientations 333. The target substrate 350 may be aligned with the donor substrate 300 by movement of a substrate chuck (e.g., the substrate chuck 320B of Figure 3G) or the support structure (e.g., the support structure 322B of Figure 3G). The donor substrate 300 and the target substrate 350 may be aligned to one another, including by both coarse and fine alignment, such as by alignment of the relative positions of one or more alignment point (e.g., the alignment point 315 of the donor substrate 300 and the alignment point 317 of the target substrate 350). In some embodiments, the donor substrate 300 and the target substrate 350 may be aligned, such as by coarse alignment. In some embodiments, once the donor substrate 300 and the target substrate 350 are aligned, one or more donor die of the donor substrate 300 may be aligned with one or more target die of the target substrate 350. In Figure 3H, the alignment of the donor die 302B with the target die 304B (e.g., of the alignment point 303B of donor die 302B with the alignment point 305B of target die 304B) is depicted. Once a donor die is aligned with a target die, that donor die may be placed on the target die, by any appropriate method, such as die actuator activation, gravitational acceleration, electrostatic actuation, etc.

In Figure 3I, an additional donor substrate (e.g., donor substrate 300-2 having a carrier structure 314-2) is placed on the substrate chuck 320A for additional placement of donor dies on target dies. In some embodiments, the additional donor substrate may be placed on the substrate chuck 320A after the substrate of the previous donor substrate is removed from the substrate chuck 320A- for example, if the substrate of a donor substrate is removed from the flipper 330 and re-placed on the substrate chuck 320A. In some embodiments, the previous donor substrate may be removed from the flipper 330 without recourse to the substrate chuck 320A, such as by removal from the flipper to an additional substrate chuck (not depicted) or any other appropriate removal procedure. The additional donor substrate may be placed on the substrate chuck 320A after the previous donor substrate is accepted by the flipper 330 or at any time when the substrate chuck 320A (or another substrate chuck) is free. The additional donor substrate (e.g., the donor substrate 300-2) may be substantially identical to or different from the previous donor substrate (e.g., the donor substrate 300). The processing of the donor substrate 300-2 by placement of the donor dies on target dies may proceed as previously described in relation to Figures 3A-3H, such as by placement on an additional target substrate (not depicted). The donor substrate 300-2 may be placed on the substrate chuck 320A while the donor dies of the donor substrate 300 are placed on the target dies of the target substrate 350, such as substantially simultaneously.

In Figure 3J, the positions of the donor die (e.g., the donor die 302A-2 to 302C-2) and/or of mark 315-2 are measured, as previously described in relation to Figure 3B.

In Figure 3J, additional donor die of the donor substrate 300 are placed on the target die of the target substrate 350. The position of the donor substrate 300, the target substrate 350, or a combination thereof may be adjusted to align an additional donor die of the donor substrate 300 with a target die of the target substrate 350. As depicted, the donor substrate 300 is positioned (such as by movement in the directions or orientations 334) to align the alignment point 303A of the donor die 302A with the alignment point 305A of the target die 304A. The donor die 302A may then be placed on the target die 304A by any appropriate method, such as previously described. The donor die 302B is depicted as bonded to the target die 304B, subsequent to their alignment at alignment point 307B in Figure 3H. As will be realized, the various steps of Figures 3A-H can be repeated as appropriate to bond multiple dies and process multiple donor and target substrates.

In some embodiments, die bonding may be performed by one or more dedicated apparatuses, such as a high-volume manufacturing tool. A tool which performs die bonding at die fabrication speeds, such as at speeds of 10 or more wafers an hour, 20 or more wafers an hour, 50 or more wafers an hour, 100 or more wafers an hour or 200 or more wafers an hour, where each wafer may contain hundreds of dies, may increase die bonding throughput in high-volume manufacturing thereby generating significant time savings and associated cost savings. Die bonding may represent a bottleneck step, where high accuracy and high speed are difficult to attain. By providing a multi-stage apparatus for die bonding, in which die positions may be measured at one stage which dies are bonded based on the measured positions at another stage, speed and accuracy may be increased. While described as dedicated, e.g., for die bonding, a dedicated apparatus may also perform additional operations not described herein, such as cleaning, surface topography metrology, die testing, etc., or be integrated with apparatuses and systems which performed additional operations.

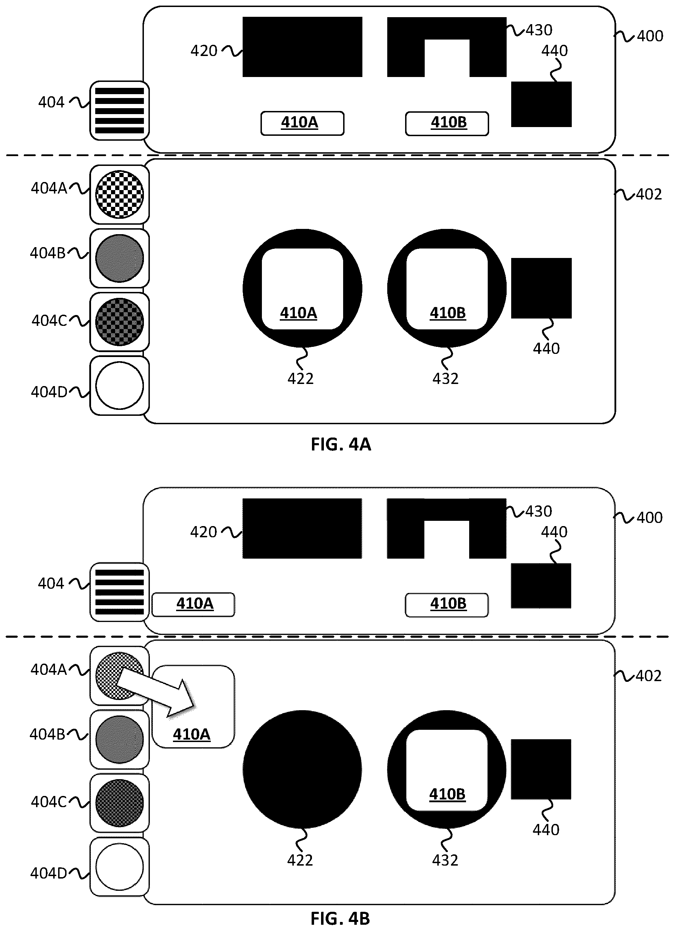

Figures 4A-4AH are schematic diagrams illustrating operations of an example multi-stage apparatus for die bonding. Each of Figures 4A-4AH depicts both an orthogonal view 400 and cross-sectional view 402 of a portion of the multi-stage apparatus. The orthogonal view 400 and the cross-sectional view 402 of each Figure 4A-4AH are not necessarily simultaneous views, but instead depict related operations performed by and with the apparatus for die bonding. The operations depicted in Figures 4A-4AH are not an exhaustive list of operations performed by the multi-stage apparatus. The operations may be performed in a different order, different combinations, different timing (e.g., a Figure may show actions occurring a similar time frame but instead one or more of those actions may occur in the context of another Figure and are depicted in the same particular Figure for convenience) , etc. than depicted. One or more operations may be omitted. One or more additional operations may be performed. In various figures, two stages are depicted. Although two stages are depicted, more stages may be used in the operations described herein. In some embodiments, fewer stages may be used.

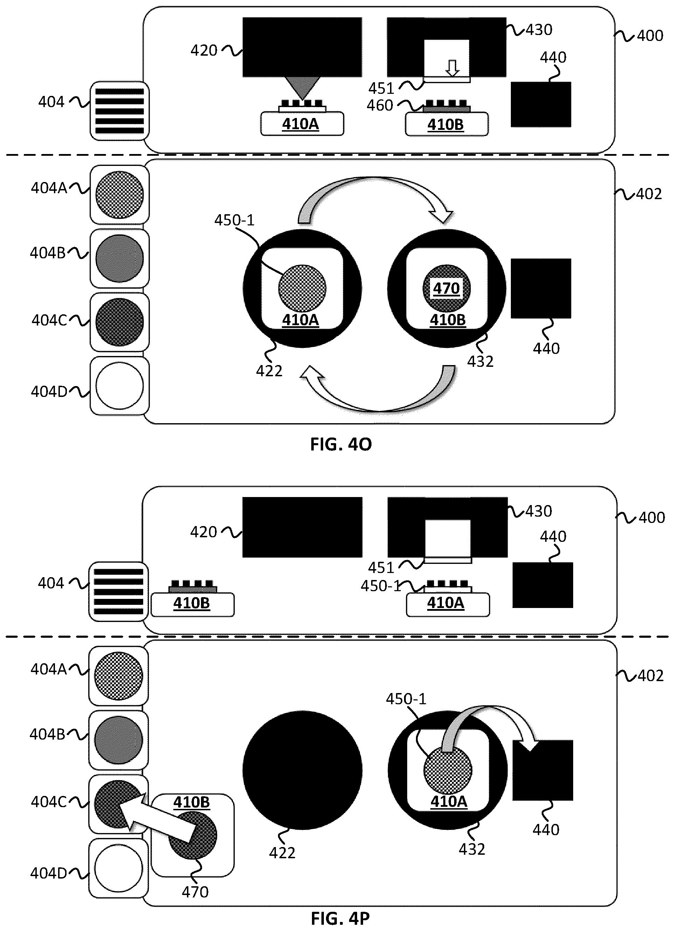

The operations depicted in Figures 4A-4AH are described in reference to one or more donor dies 450, which may be supported by a donor substrate. The description here focuses, in a nonlimiting manner, on a donor substrate comprising a carrier structure 451 (e.g., comparable to any carrier structure described herein). The donor dies 450 may be placed on the carrier structure 451 (see Fig. 4O) by any appropriate means. The carrier structure 451 may be any appropriate carrier structure, including a carrier structure which is at least partially transparent and/or otherwise configured for use with light induced forward transfer (LIFT) or another light mediated method of donor die placement on one or more target locations. The one or more donor dies 450 may be of any appropriate size, up to an including a full wafer size, and/or shape. In an embodiment, the donor substrate may be a wafer comprising one or more dies formed therein (e.g., a conventional semiconductor wafer) or a part of such a wafer.

The operations depicted in Figures 4A-4AH are described in reference to one or more target dies and/or target substrates and which have one or more target locations. The one or more target dies may be in, or supported by, a target substrate 460. In an embodiment, the target substrate comprises a carrier structure (e.g., comparable to any carrier structures described herein). The one or more target dies may be supported by any appropriate support structure, which may or may not be at least partially transparent and/or otherwise configured for use with LIFT or another light mediated method of donor die placement. In an embodiment, the target substrate may be a wafer comprising one or more dies formed therein (e.g., a conventional semiconductor wafer) or a part of such a wafer.

Figures 4A-4AH are described with reference to "donor" and "target" (e.g., or "acceptor") die, locations, wafers, etc. These terms are relative as used herein, and a donor may instead be a target. Likewise, stages of the multi-stage apparatus are referred to as a first stage and a second stage for ease of description and depiction only, and such stages may or may not be physically interchangeable.

As depicted in Figures 4A-4AH, the multi-stage apparatus may accept die (e.g., donor die 450) and/or substrates (e.g., target substrate 460) from one or more Front Opening Unified Pots (FOUPs) 404. The use of FOUPs may enable cleaned dies, wafers and/or carrier structures to be delivered to the multi-stage apparatus from one or more other process tools. The interior of the multi-stage apparatus may maintain a clean environment (e.g., an ISO classification or other cleanroom standard) which may require the use of FOUPs. A particle-free environment may be maintained within the multi-stage apparatus by a particle elimination system (not depicted), which may include inert gas flow, vacuum, dust handling equipment, etc. Each type of die/wafer/carrier structure delivered to the multi-stage apparatus may be delivered in a FOUP. The carrier structure 451 on which the donor die 450 lie (or on which target die may lie) may enable the use of FOUPs with donor die, where diced donor die may be too small to transport in FOUPs without a wafer sized carrier structure. The carrier structure 451 may also function to provide rigidity to the donor die, such that the carrier structure and donor die together function, in at least some ways, like a full wafer for wafer handling purposes. The donor die 450 may be affixed to the carrier structure 451 by any appropriate means, including expandable adhesive. The carrier structure 451 may also include one or more layers of foil, polymer, flexible interposer, etc. between the carrier structure 451 and the donor die 450. These considerations also apply to use a carrier structure, like carrier structure 451, with one or more target dies.

The multi-stage apparatus may receive donor die 450 (as a wafer or on an associated carrier structure) from a donor die FOUP 404A. The multi-stage apparatus may receive a target substrate 460 from a target substrate FOUP 404B. The multi-stage apparatus may deliver a die bonded target substrate and donor die 470 to a bonded FOUP 404C. The multi-stage apparatus may deliver a carrier structure 451, which may no longer support donor die or which may support only donor die which have not successfully die bonded, to a carrier structure FOUP 404D.

The multi-stage apparatus may have a measurement system 420. The measurement system 420 may be any appropriate measurement system, such as described in reference to Figures 3A-3J. The measurement system 420 may have more than one type of sensor. In an embodiment, the measurement system 420 has a sensor to measure the position of features for alignment as described herein. In an embodiment, the measurement system 420 has a sensor to measure a topography, e.g., to determine unflatness and/or the presence of particles which may hinder effective bonding. Of course, the apparatus can process such measured information to take appropriate actions, e.g., corrective action.

The multi-stage apparatus may have a bonding system 430. The bonding system may be a light induced forward transfer (LIFT) bonding system. The bonding system may be any appropriate bonding system, such as described in reference to Figures 3A-3J. The multi-stage apparatus may have a flipper 440, which may be any appropriate substrate inversion or flipping system, such as described in reference to Figures 3A-3J. The bonding system 430 may have one or more different types of sensor. In an embodiment, the bonding system 430 has a sensor to measure the position of features for alignment as described herein, e.g., to measure donor die positions prior to bonding, as described herein. In an embodiment, the bonding system 430 has a sensor to determine a level of a donor die and/or target location to enable matching of bonding surfaces. Of course, the apparatus can process such measured information to take appropriate actions, e.g., corrective action.

In an embodiment, measurement functions (e.g., alignment measurement, topography measurement, level measurement, etc.) can be at different locations and are not all required to be, for example, at measurement system 420. There may be one or more measurement functions at measurement system 420 but one or more measurement functions elsewhere (including but not limited to at bonding system 430).

The multi-stage apparatus may have two or more moveable stages, such as moveable stages 410A and 410B. The moveable stages may be configured to move about an operational plane of the multi-stage apparatus. The operational plane may be a substantially flat two-dimensional plane of the multi-stage apparatus upon which the operations of die bonding occur. The moveable stages may be moveable by actuation of stepper motors, drivers, a planar motor (e.g., comprising one Halbach arrays), magnetic drives, etc. The moveable stages may be moveable by operation of one or more arms or cross bars. See, e.g., U.S. Patent Nos. 7161659 and 6531793, which are incorporated herein in their entireties by reference, for example multi-stage apparatuses in a different application but adaptable for the application herein. The moveable stages may be able to move in free space (of at least two dimensions). The moveable stages may be moveable about the operational plane in one or more directions, including in two substantially perpendicular directions. The moveable stages may move about the operational plane, including into and out of regions corresponding to the measurement system (e.g., region 422) and the bonding system (e.g., region 432). In some embodiments, when a moveable stage provides a donor die 450, carrier structure 451, target substrate 460, die bonded target substrate and donor die 470, etc. to the region 422, the measurement system may be enabled to measure positions of the die and/or substrate. In some embodiments, when a moveable stage provides a donor die 450, carrier structure 451, target substrate 460, die bonded target substrate and donor die 470, etc. to the region 432, the bonding system may be enabled to bond the die and/or substrate. In some embodiments, a region of the operational plane may be accessible to the flipper 440 (that is, when a moveable stage is in the region of the operational plane accessible to the flipper 440, a substrate or carrier structure on that moveable stage may be flipped). In some embodiments, the region of the operational plane accessible to the flipper may be the region 432 accessible to the bonding system 430-that is, a carrier structure or donor die may be flipped directly from the region 432 where it is accessible to the bonding system 430. In an embodiment, a moveable stage 410A and/or 410B may have one or more different types of sensor therein. For example, a stage may have a sensor to determine a relative position between it and a donor die and/or to determine a relative level between it and a donor die.

In Figure 4A, a non-bonding configuration of the multi-stage apparatus is depicted. This may correspond to a neutral position of the moveable stages (e.g., the moveable stage 410A and the moveable stage 410B), such as a safe position for transport, maintenance, rest, etc. Each of the moveable stages may be empty and awaiting donor die and target substrates for a bonding operation.

In Figure 4B, the first moveable stage 410A may approach the donor die FOUP 404A in order to receive a donor die (e.g., supported on a carrier structure or in the form of a wafer) from the given FOUP in order to begin the die bonding process.

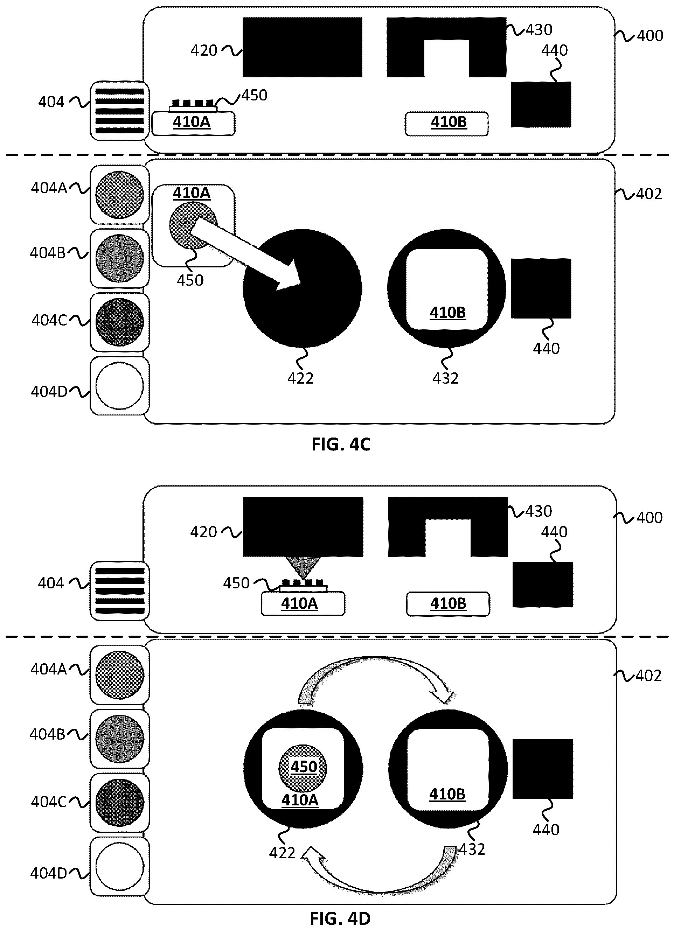

In Figure 4C, the first moveable stage 410A may receive the donor die 450 from the donor die FOUP 404A and may transport the donor die 450 (e.g., on the associated carrier structure) to the region 422 for measurement by the measurement system 420.

In Figure 4D, the positions of the donor die 450 are measured by the measurement system 420. Once the positions of the donor die 450 are measured, the first moveable stage 410A may move to the region 432 corresponding to the bonding system 430. The second moveable stage 410B may switch positions with the first moveable stage 410A or move to any other appropriate location. While the embodiment herein show stages 410A and 410B exchanging positions, it is possible to have different configurations. As one example, there could be another measurement system and associated measurement region opposite region 422 for measurement by measurement system 420 and so the stages 410A and 410B may then shuttle back and forth with only stage 410A going to region 422 and only stage 410B going to the other measurement region.

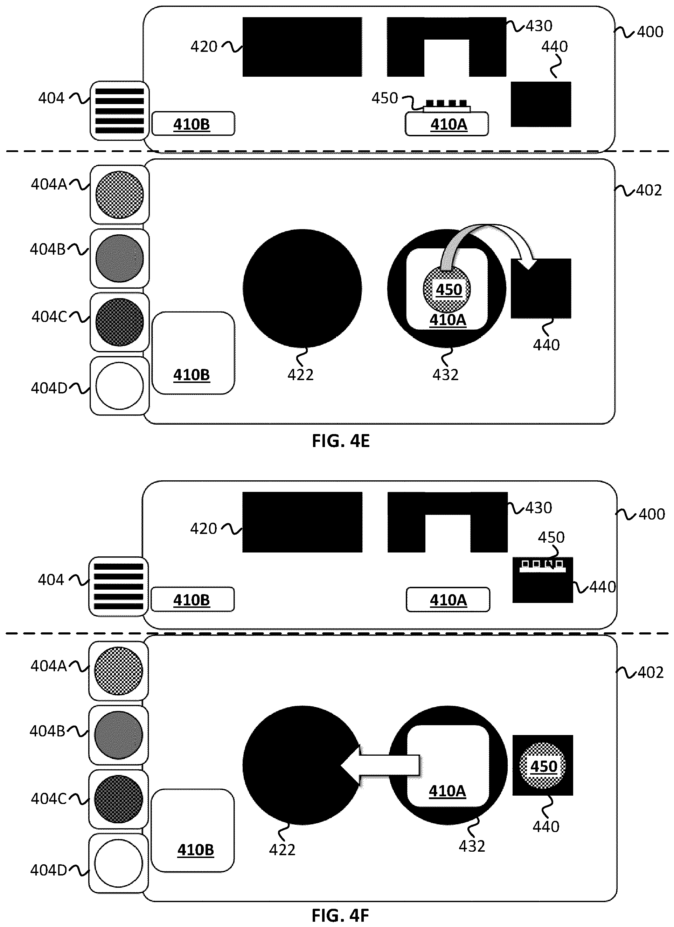

In Figure 4E, the second moveable stage 410B may approach the target substrate FOUP 404B in order to receive a target substrate from the given FOUP. Alternatively, the second moveable stage 410B may move to a part of the operational plane from which it does not obstruct the movement of the first moveable stage 410A and/or the flipper 440. The donor die 450 may be accepted by the flipper 440 from the region 432 (or any other appropriate region).

In Figure 4F, the donor die 450 may be removed from the first moveable stage 410A onto the flipper 440 (e.g., may be held by the flipper 440 instead of the first moveable stage 410A). The moveable stage 410A may move to another location, e.g., to region 422. This may be, e.g., to enable room for the flipping and placement of the donor die 450 into or onto the bonding system 430.

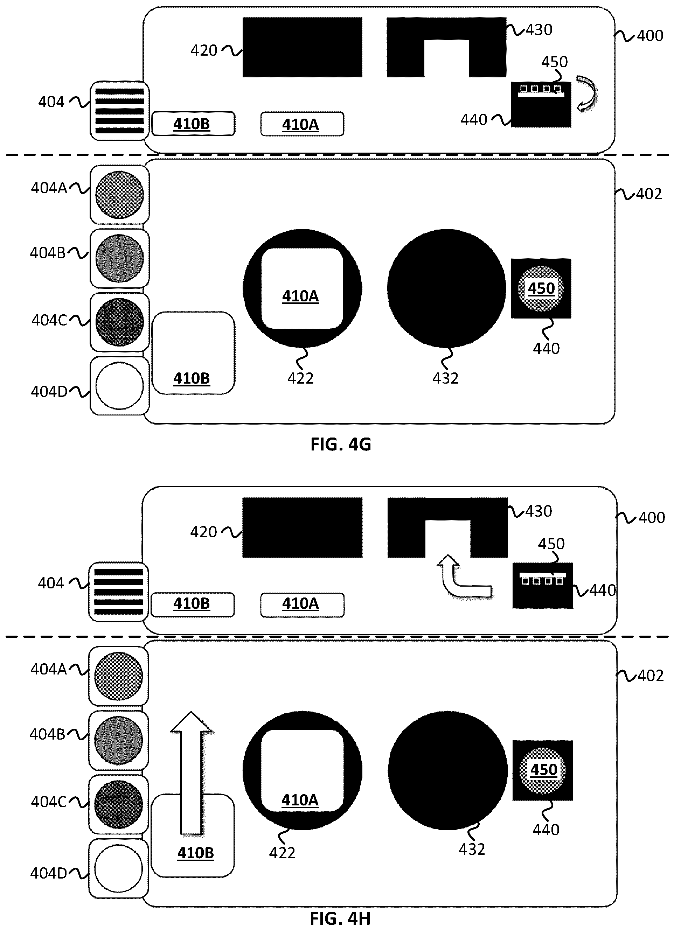

In Figure 4G, the flipper 440 may flip the donor die 450 so that a bonding plane of the donor die 450 faces in a substantially opposite direction (e.g., down towards the operational plane).

In Figure 4H, the flipped donor die may be placed in a holder of the bonding system 430, such that the flipped donor die 450 is at least partially aligned with the region 432 of the operational plane.

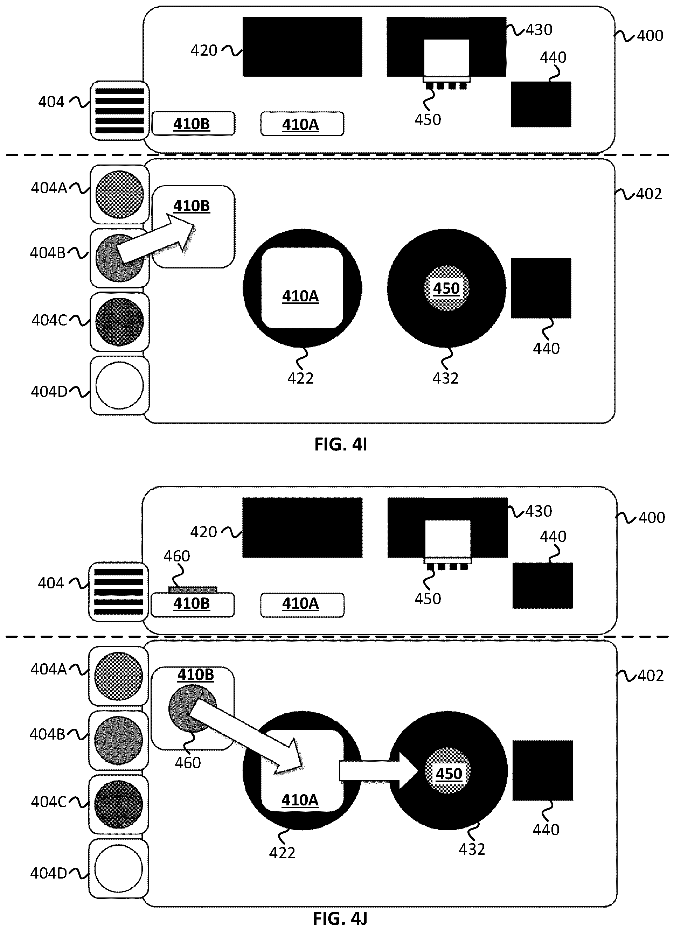

In Figure 4I, the second moveable stage 410B may accept a target substrate 460 from the target substrate FOUP 404B.

In Figure 4J, the second moveable stage 410B may transport the target substrate to the region 422 corresponding to the measurement system 420. The first moveable stage 410A may move to the region 432 or any other appropriate region so that the second moveable stage 410B may complete its movements.

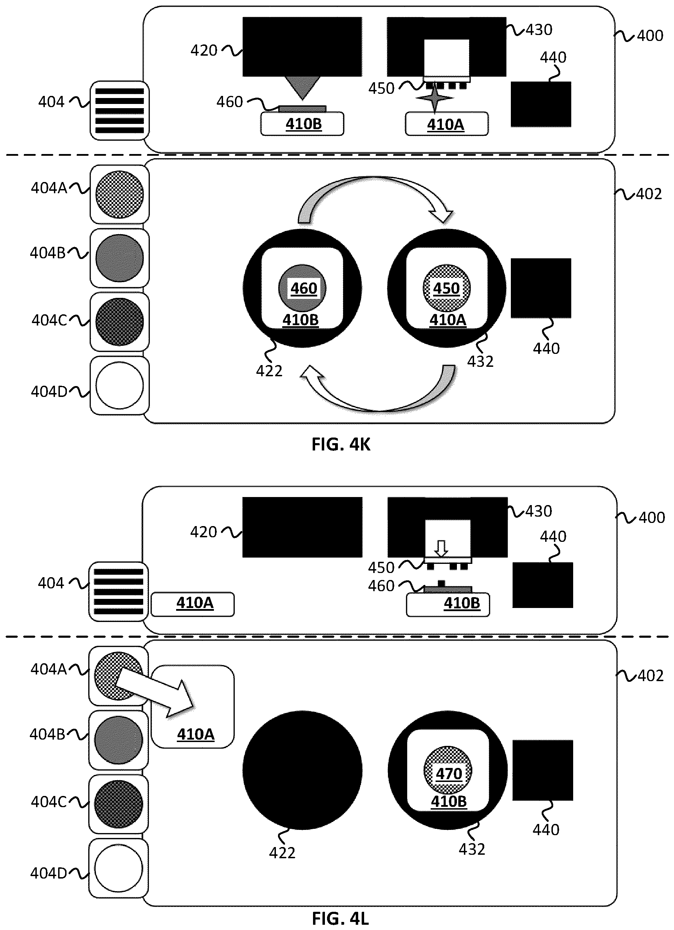

In Figure 4K, the positions of locations on the target substrate 460 (or on target die) are measured by the measurement system 420. In some embodiments, one or more measurements may also be taken of the flipped donor die 450, such as to determine bowing of the carrier structure under gravity. In some embodiments, the measurements of the flipped donor die 450 may be acquired by a measurement system integrated into the bonding system 430, such as by laser interferometry, stress measurements, etc. In some embodiments, the measurements of the flipped donor die 450 may be acquired by a measurement system integrated into the stage 410A, such as by laser interferometry, stress measurements, etc. Once the positions of the locations on the target substrate 460 are measured, the second moveable stage 410B may move to the region 432 corresponding to the bonding system 430.

In Figure 4L, the flipped donor die 450 and the target substrate 460 may be aligned, such as by movement of the second moveable stage 410B. One or more of the donor die 450 and the locations on the target substrate 460 may be aligned and selectively (that is, selected by virtue of being aligned out of all the donor die 450 and locations on the target substrate 460) die bonded. Any of the die bonding techniques described herein can be used. In an embodiment, the method of die bonding may include light-mediated release of the donor die 450 from the carrier structure held in the bonding system 430. The first moveable stage 410A may approach the donor die FOUP 404A in order to receive an additional donor die and carrier structure for die bonding.

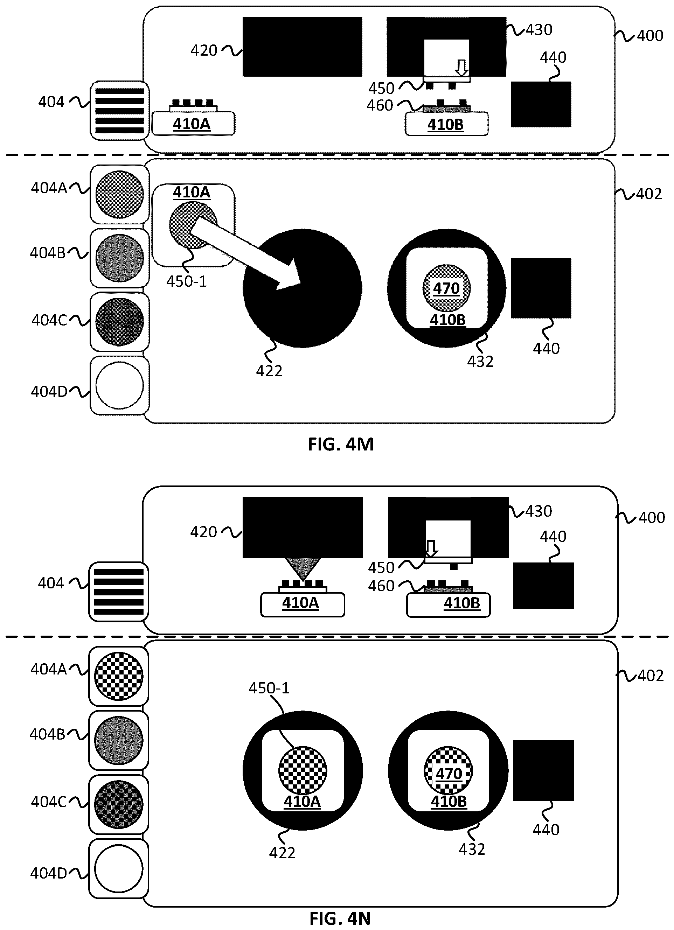

In Figure 4M, the first moveable stage 410A may receive an additional donor die 450-1 and carrier structure from the donor die FOUP 404A and may transport the donor die 450-1 to the region 422 for measurement by the measurement system 420. A further one or more of the donor die 450 and the locations on the target substrate 460 may be aligned and selectively (that is, selected by virtue of being aligned out of all the donor die 450 and locations on the target substrate 460) die bonded, by any appropriate method. So, in an embodiment, the die bonding and measurement can occur at least partially in parallel.

In Figure 4N, the positions of the additional donor die 450-1 are measured by the measurement system 420. A further one or more of the donor die 450 and the locations on the target substrate 460 may be aligned and selectively (that is, selected by virtue of being aligned out of all the donor die 450 and locations on the target substrate 460) die bonded, by any appropriate method.

In Figure 4O, the alignment and bonding of the donor die 450 and the locations of the target substrate 460 may continue until all the donor die 450 are processed (e.g., bonded to the target substrate or rejected for bonding). Once the locations of the additional donor die 450-1 are measured and the donor die 450 bonded, the second moveable stage 410B may switch positions with the first moveable stage 410A or move to any other appropriate location, so that the first moveable stage 410A may move to position the additional donor die 450-1 in the region 432 corresponding to the bonding system 430. The bonded target substrate and donor die 470 may be removed from the region 432 by the second moveable stage 410B, which may switch places with the first moveable stage 410A (previously in region 422) or move to another location.

In Figure 4P, the additional donor die 450-1 may be removed from the first moveable stage 410A by the flipper 440 (e.g., may be held by the flipper 440 instead of the first moveable stage 410A). The bonded target substrates and donor die 470 may be moved to the bonded target substrate and donor die FOUP 404C by the second moveable stage 410B.

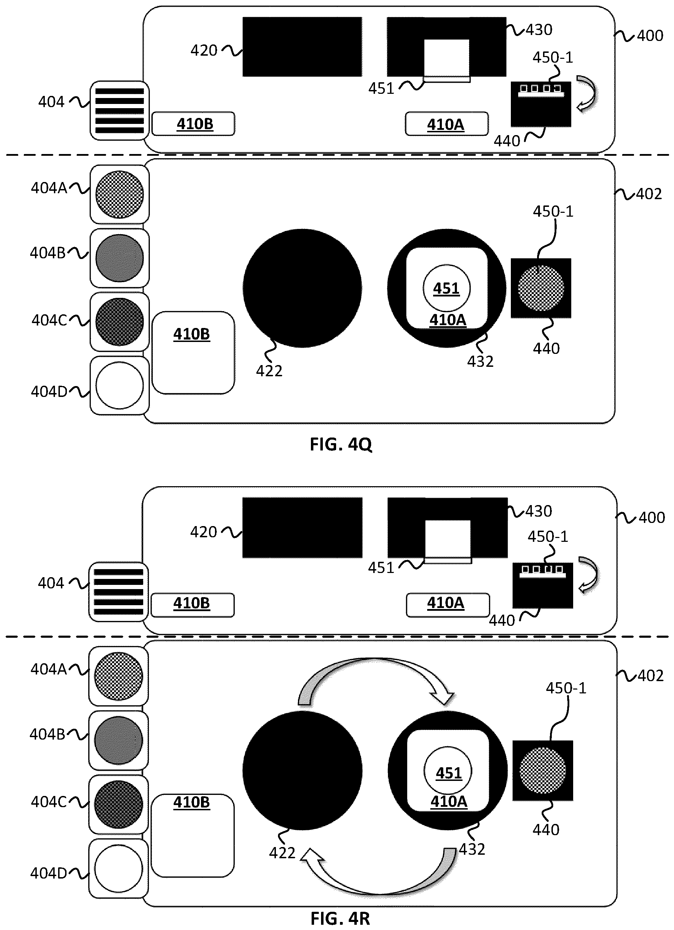

In Figure 4Q, the bonded target substrate and donor die FOUP 404C has accepted the bonded target substrate and donor die 470 and the additional donor die 450-1 are supported by the flipper 440.

In Figure 4R, the first moveable stage 410A may switch positions with the second moveable stage 410B or move to any other appropriate location, so that the second moveable stage 410B can become aligned with the bonding system 430. The additional donor die 450-1 are supported by the flipper 440.

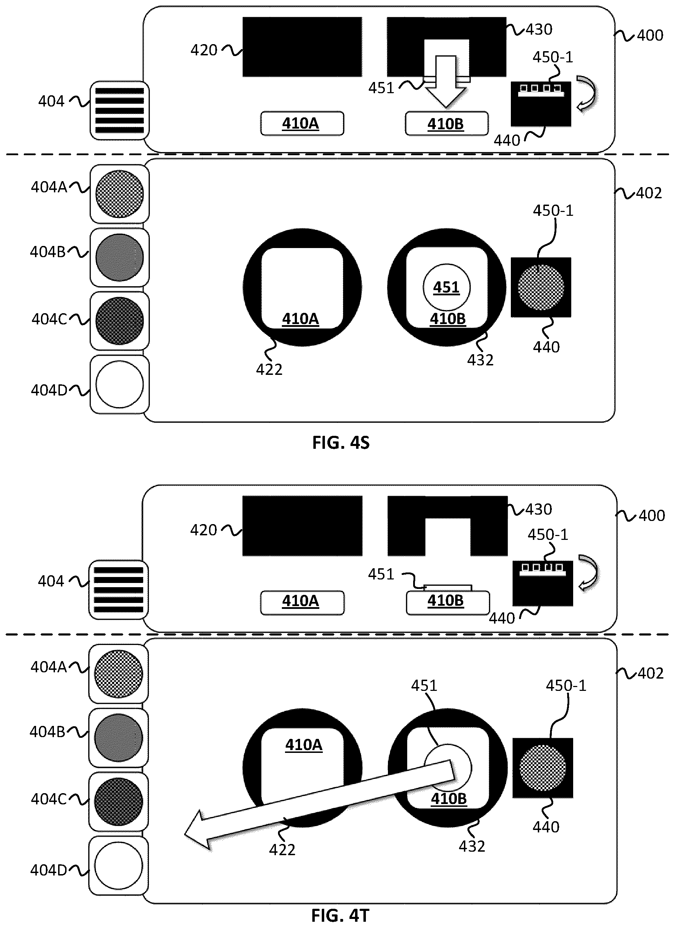

In Figure 4S, the carrier structure 451 may be released from the bonding system 430 to the second moveable stage 410B. For example, second moveable stage 410B moves up toward the bonding system 430 and then the bonding system 430 releases the carrier structure 451. Additionally or alternatively, the bonding system 430 can be moved by an actuator in a vertical direction toward the second moveable stage 410B and then release the carrier structure. An actuator of the bonding system 430 may also be used for relative alignment between the bonding system and an applicable stage and/or be used to cause displacement of a donor die to a target location to aid in bonding.

In Figure 4T, the second moveable stage 410B may transport the carrier structure 451 (e.g., without donor die 450) to the carrier structure FOUP 404D.

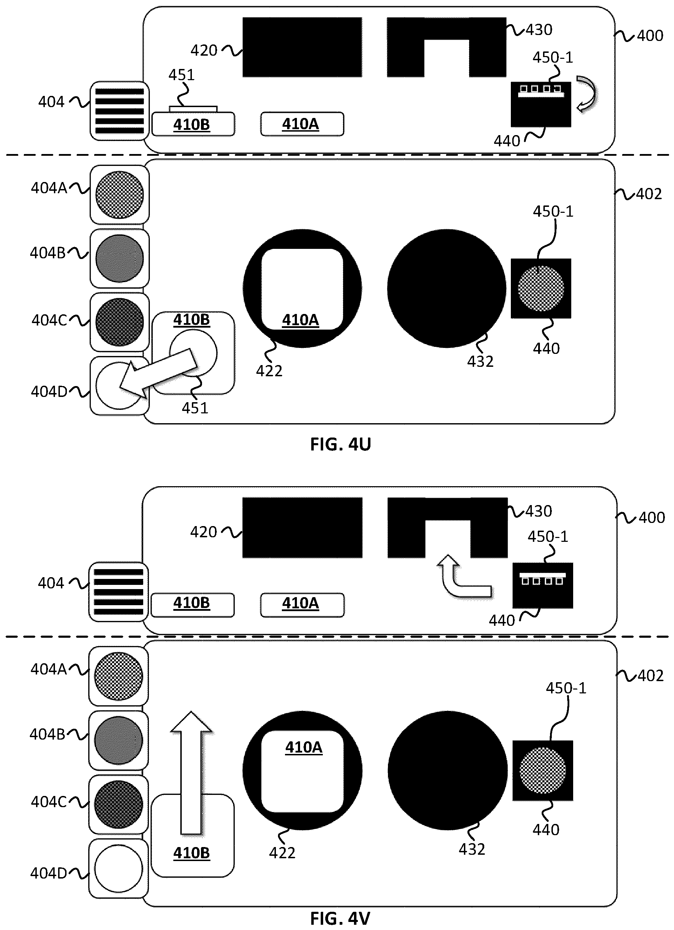

In Figure 4U, the carrier structure FOUP 404D may accept the carrier structure 451.

In Figure 4V, the additional donor die 450-1 may be flipped by the flipper 440 by an appropriate manner. The second moveable stage 410B may approach the target substrate FOUP 404B to receive an additional target substrate.

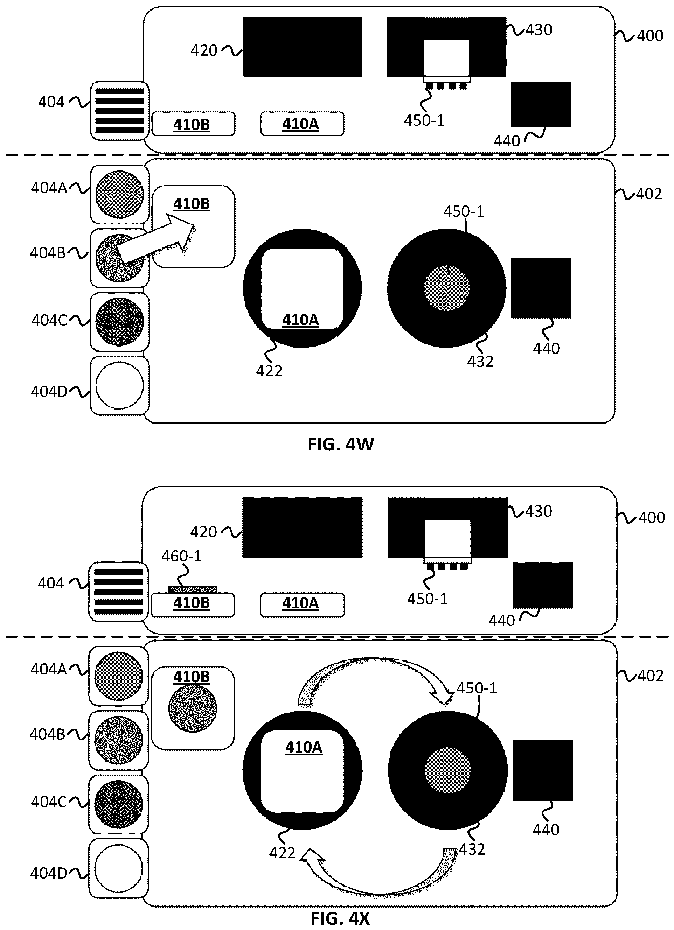

In Figure 4W, the second moveable stage 410B may accept an additional target substrate 460-1 from the target substrate FOUP 404B.

In Figure 4X, the first moveable stage 410A may move to the region 432 so that the region 422 may be available for the second moveable stage 410B. The second moveable stage 410B carrying the additional target substrate 460-1 may move to region 422.

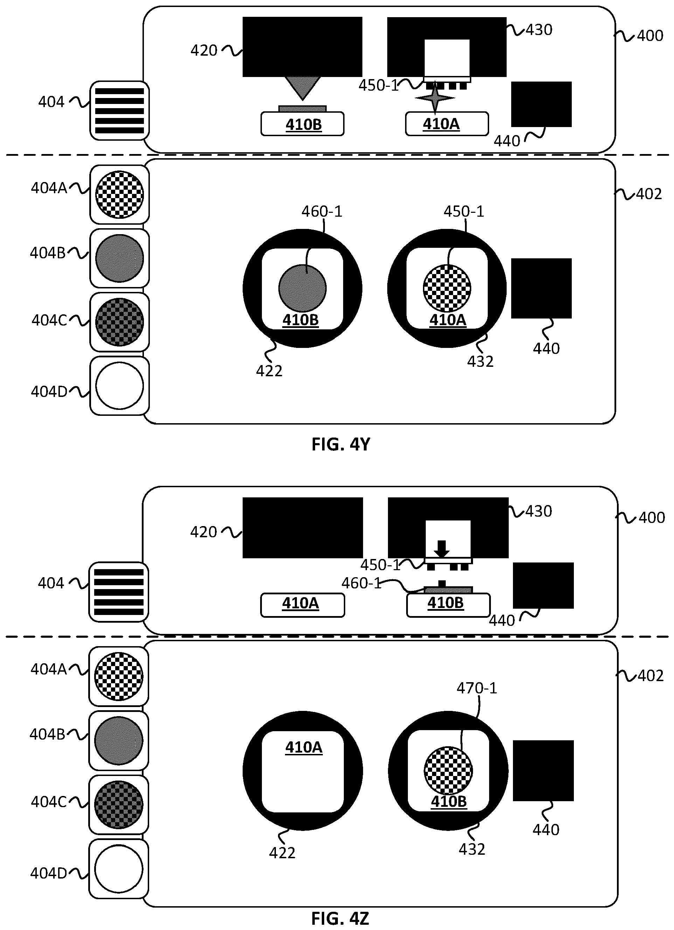

In Figure 4Y, the positions of locations on the additional target substrate 460-1 (or on target die) are measured by the measurement system 420. In some embodiments, one or more measurements may also be taken of the flipped additional donor die 450-1, such as to determine bowing of the carrier structure under gravity. In some embodiments, the measurements of the flipped additional donor die 450-1 may be acquired by a measurement system integrated into the bonding system 430, such as by laser interferometry, stress measurements, etc. In some embodiments, the measurements of the flipped additional donor die 450-1 may be acquired by a measurement system integrated into the stage 410A, such as by laser interferometry, stress measurements, etc. Once the positions of the locations on the additional target substrate 460-1 are measured, the second moveable stage 410B may move to the region 432 corresponding to the bonding system 430. The first moveable stage 410A may switch positions with the second moveable stage 410B or move to any other appropriate location, so that the second moveable stage 410B can become aligned with the bonding system 430.

In Figure 4Z, one or more of the additional donor die 450-1 and the locations on the additional target substrate 460-1 may be aligned and selectively die bonded together, by any appropriate method.

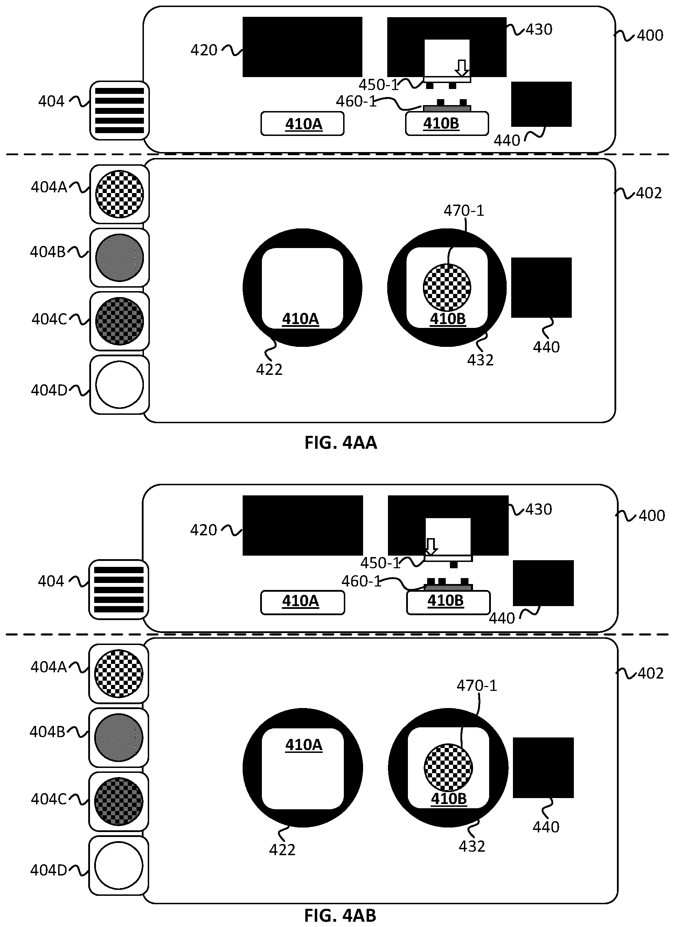

In Figure 4AA, a further one or more of the additional donor die 450-1 and the locations on the additional target substrate 460-1 may be aligned and sequentially die bonded, by any appropriate method.

In Figure 4AB, a further one or more of the additional donor die 450-1 and the locations on the additional target substrate 460-1 may be aligned and sequentially die bonded, by any appropriate method.

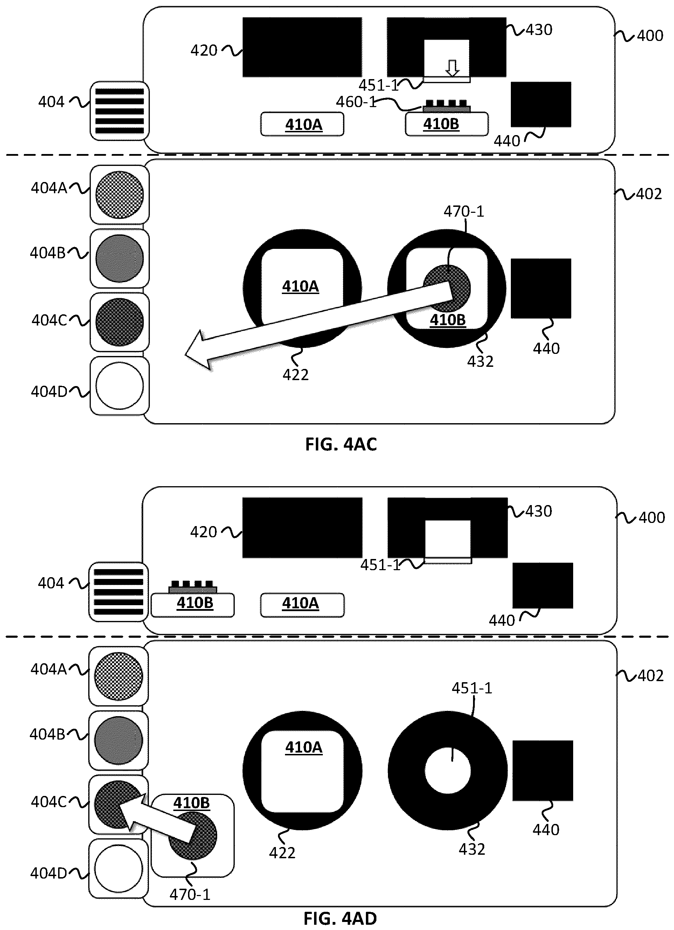

In Figure 4AC, the alignment and bonding of the additional donor die 450-1 and the locations of the additional target substrate 460-1 may continue until all the additional donor die 450-1 are processed (e.g., bonded to the target substrate or rejected for bonding), to produce an additional bonded target substrate and donor die 470-1. The second moveable stage 410B may operate to move the additional bonded target substrate and donor die 470-1 towards the bonded target substrate and donor die FOUP 404C.

In Figure 4AD, the bonded target substrate and donor die FOUP 404C may accept the additional bonded target substrate and donor die 470-1.

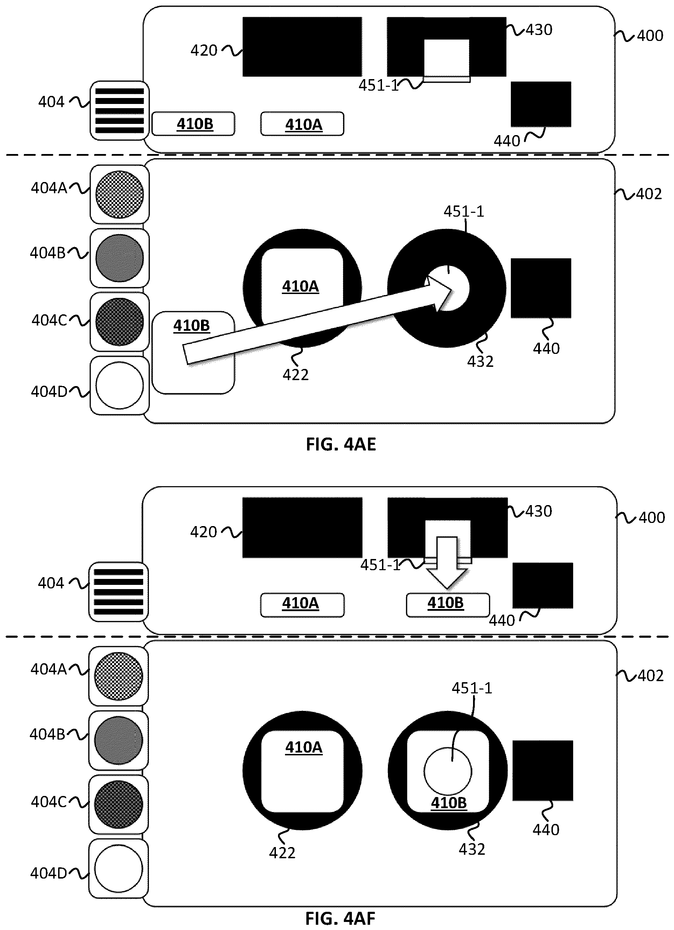

In Figure 4AE, the second moveable stage 410B may return to the region 432 in order to receive the additional carrier structure 451-1, which may be clear of donor dies remaining for bonding or may still have one or more dies thereon not bonded (e.g., rejected).

In Figure 4AF, the additional carrier structure 451-1 may be released from the bonding system 430 to the second moveable stage 410B for transport, e.g., using the methods described herein with respect to carrier structure 451.

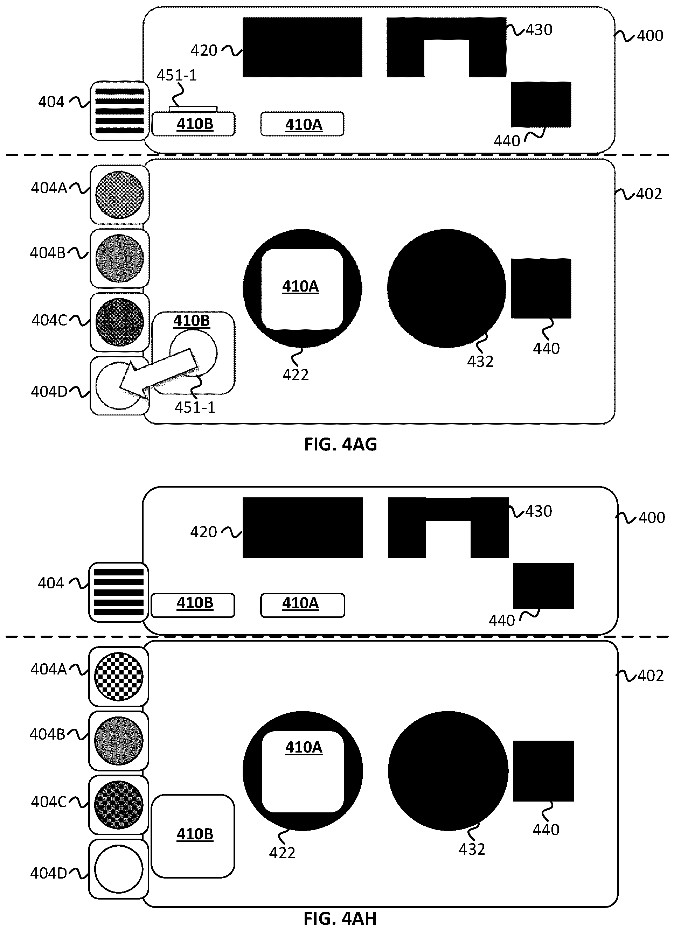

In Figure 4AG, the additional carrier structure 451-1 may be transported by the second moveable stage 410B to the carrier structure FOUP 404D.

In Figure 4AH, the carrier structure FOUP 404D may accept the additional carrier structure 451-1.

As will be appreciated, the steps in Figures 4A-4AH can be repeated over and over to process multiple dies. It should be understood that the operations described in reference to Figures 4A-4AH are provided for reference, and move steps, including operations processing additional donor die and carrier structures, target substrates, etc., may occur. For example, a FOUP may contain 25 or more substrates, all of which may be processed in a single process. In some embodiments, multiple FOUPs may be loaded at the same time (e.g., in a batch process). In some embodiments, various FOUPs may have different capacities and may be switched in and out of the multi-stage apparatus as they fill and/or empty, such that the loading process may approximate a continuous-flow process.

In an embodiment, the methods and processes have been described with respect to two stages. However, depending on speed and timing, it may be possible to use just one stage to move between regions 422 and 432. For example, the donor die may be measured at region 432 while the target substrate is measured at region 422 and thus enable use of just one moveable stage. Additionally, the adding or removing of objects (e.g., dies, substrates, carrier structures, bonded dies, etc.) from the stage can occur at region 422 and/or region 432 to save time. Additionally or alternatively, there can be an additional measurement region, e.g., in a FOUP, to parallelize measurement with other actions.

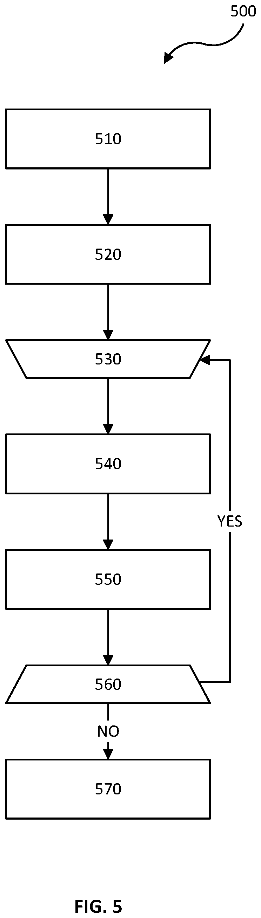

Figure 5 is a flowchart which illustrates an exemplary method of die placement. Each of these operations is described in detail below. The operations of method 500 presented below are intended to be illustrative. In some embodiments, method 500 may be accomplished with one or more additional operations not described, and/or without one or more of the operations discussed. Additionally, the order in which the operations of method 500 are illustrated in Figure 5 and described below is not intended to be limiting. In some embodiments, one or more portions of method 500 may be implemented (e.g., by simulation, modeling, etc.) in one or more processing devices (e.g., one or more processors). The one or more processing devices may include one or more devices executing or causing execution of some or all of the operations of method 500 in response to instructions stored electronically on an electronic storage medium. The one or more processing devices may include one or more devices configured through hardware, firmware, and/or software to be specifically designed for execution of one or more of the operations of method 500, for example.

At an operation 510, a plurality of donor die locations are obtained. The donor die locations may be obtained via measurement of one or more positions of the donor dies along one or more dimensions. The donor dies may lie on or be part of a donor substrate (e.g., a carrier structure, a semiconductor wafer, etc.), and the locations of the plurality of donor dies may be obtained with respect to that donor substrate. The locations of the plurality of donor die may be measured with respect to a measurement mark. The locations of the plurality of donor dies may be measured in-plane (e.g., in the x-y plane). The locations of the plurality of donor dies may also be measured via a first method in-plane and measured out of plane (e.g., in the Z direction) via a second method. For example, the locations of the plurality of donor dies may be measured based on one or more images in-plane. The locations of the plurality of donor dies may be obtained from a two-dimensional image, which may show locations of an edges or corner of a donor die with respect to positions on a support structure or on a die actuator. The locations of the plurality of donor dies may be obtained based on one or more features (for example, one or more electrically active areas) on an exposed surface of the donor die. These one or more features of the donor die may be used as an alignment mark or reference mark. In some embodiments, alignment marks may be included as exposed features of the donor die. The alignment marks may be specifically added for die bonding or may be alignment marks corresponding to previous fabrication steps. The plurality of donor die locations may be measured or obtained from storage.

At an operation 520, a plurality of target die locations are obtained. The target dies may lie on or be part of a target substrate (e.g., a carrier structure, a semiconductor substrate, etc.), and the locations of the plurality of target dies may be obtained with respect to that target substrate. The locations of the plurality of target die may be obtained in any appropriate method, including any of those described in reference to the operation 510.

At an operation 530, a donor die is selected from the plurality of donor dies. The donor die may be selected based on position (e.g., along a row, along a column), displacement (e.g., donor die closest to an ideal position), thickness (e.g., thicker dies may be placed before thinner dies, including if donor dies include two or more types of dies), etc. The donor die may have a corresponding target die, such as a target die in a corresponding location on a target substrate (e.g., target die carrier structure). In some embodiments, a target die may be selected, by any appropriate method, and a donor die selected based on its correspondence to the selected target die. The donor die and the target die may be brought together such that donor die and its corresponding target die are separated by a distance which may be traversed by the die placement method. The donor die and target die may be grossly aligned (e.g., coarse aligned), such as to within a threshold of coarse alignment. The donor die and target die may be held in proximity by one or more substrates, chucks, actuators, adhesives, etc.

At an operation 540, the relative position between the selected donor die and the corresponding target die is adjusted to have alignment between the donor die and the corresponding target die. Adjusted includes cases in which locations are minimally or substantially not adjusted (e.g., after measurement or bringing into proximity), such as if a measured location corresponds to the target location within a threshold. In an embodiment, the position of the donor die may be adjusted by action of a die actuator, a substrate holder, a chuck, etc. The position of the donor die may be adjusted by action of a substrate handling apparatus. The position of the donor die may be adjusted in one or more directions, such as in the X-Y plane. Alternatively or additionally to adjustment of the location of the donor die, the position of the target die may be adjusted, by any appropriate method, such as any of those previously described. Adjustment of the relative position between the donor and target die may include iterative measurement of donor and/or target die location, including as adjustment occurs.

Adjustment of the location of the donor die may occur based on an alignment location for the donor die. The alignment location may be a target (e.g., target location) for placement of the donor die. A target (e.g., target location) may be obtained, such as at operation 520, from measurement of the target die position. The target may correspond to a location of the target die. The target may correspond to a plurality of locations on the target die. The target may be a position (e.g., a position in three dimensions such as along X, Y, and Z axes, positions in six directions such as along X, Y, and Z axes and with respect to angles of rotation about those axes, etc.). The target may be a set of positions, for example two or more positions of or on a target die to which areas of the donor die are to be bonded. Additionally or alternatively, adjustment of the location of the target die may occur based on an alignment location for the target die. The alignment location may be a target (e.g., target location) for placement of the donor die. A target (e.g., target location) may be obtained, such as at operation 510, from measurement of the donor die position. The target may correspond to a location of the donor die. The target may correspond to a plurality of locations on the donor die.

At an operation 550, the selected donor die is placed on the corresponding target die. The donor die may be placed on the target die by any appropriate method, such as by movement of a die actuator, by radiation-mediated bonding, by stamping, by electrostatic attraction, etc. The donor die may experience alignment, including self-alignment, as the donor die is brought into contact with the target die. The donor die may be adhered to the target die as it contacts the target die, such as by van der Waals forces. In some embodiments, an additional donor die may be placed on the same or different target die.

At an operation 560, it is determined if additional donor die remain for placement. If additional donor die (e.g., on the donor substrate) remain for placement, the flow continues to the operation 530 where another donor die is selected. If no additional donor die remain for placement, flow continues to operation 570, where the bonding of the plurality of dies is completed.

In an embodiment, a particular donor die and target die are bonded at the time the donor die is placed on the target die, e.g., through intermolecular bonding. In an embodiment, the donor die is bonded, such as through annealing or other bonding process, to the target die after placement of the donor die on the target die. In an embodiment, a bonding of a donor and target die is completed before a next donor die is placed on a target die. In an embodiment, bonding of a donor and target die is completed after a plurality of donor dies are placed on respective target dies, e.g., after all the donor dies on a donor substrate are placed. In an embodiment, a donor die placed on a target die is annealed to form or enhance electrical connection. In an embodiment, the annealing of a particular donor die and target die can be done prior to a next donor die is placed on a target die. In an embodiment, annealing of a donor and target die is completed after a plurality of donor dies are placed on respective target dies, e.g., after all the donor dies on a donor substrate are placed. The donor die may be held against the target die for a bonding or annealing time period. A donor die and target die pair may be released from a substrate or other holding apparatus before annealing or after annealing has occurred.

As described above, method 500 (and/or the other methods and systems described herein) is configured for die placement.

In an embodiment, the techniques and apparatus herein can be applied to die to die bonding, substrate to substrate bonding, die to substrate bonding, etc. For example, the techniques and apparatus herein can be applied to bonding an individual donor die to an individual target die. In an embodiment, the techniques and apparatus herein can be applied to bonding a group of donor dies to one or more target dies at a substantially same time or a group of target dies to one or more donor dies at a substantially same time. In an embodiment, the techniques and apparatus herein can be applied to bonding one or more donor dies to a substrate comprising one or more target dies formed therein or thereon or bonding one or more target dies to a substrate comprising one or more donor dies formed therein or thereon. In an embodiment, the techniques and apparatus herein can be applied to bonding a full or partial substrate comprising donor dies to one or more target dies or bonding a full or partial substrate comprising target dies to one or more donor dies. Thus, the techniques and apparatus herein can be applied to practically every form of die bonding, whether bonding dies individually, bonding dies in a group, bonding dies as part of a full or partial substrate, etc.

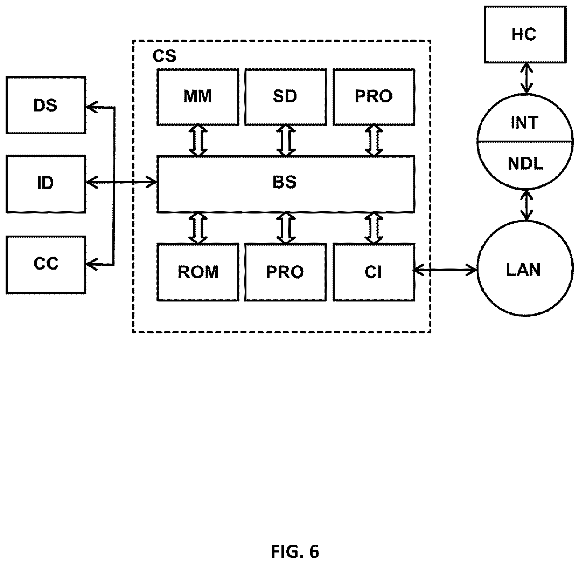

Figure 6 is a diagram of an example computer system CS that may be used to implement one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform one or more process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or radiation waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments include the following numbered clauses:
Clause 1: A system for die bonding, the system comprising:
   a first stage configured to support one or more donor dies;
   a second stage configured to support one or more target dies;
   a measurement system configured to measure a position of the one or more donor dies and configured to measure a position of the one or more target dies; and
   a positioner system configured to provide relative movement between at least one of the one or more donor dies and a corresponding one of the one or more target dies for die bonding by movement of the first stage and/or the second stage.
Clause 2: The system of clause 1, wherein the positioner system is configured to drive the first stage and/or the second stage about an operational plane, the operational plane comprising an area about which the first stage and/or the second stage are moveable.
Clause 3: The system of clause 2, wherein the first stage and/or the second stage is moveable in both dimensions of the operational plane.
Clause 4: The system of clause 2 or clause 3, wherein the first stage and/or the second stage is moveable about the operational plane by operation of a planar motor.
Clause 5: The system of any preceding clause, wherein the positioner system is configured to drive the first stage to:
   support the one or more donor dies at a first measurement position for measurement; and
   transport the one or more donor dies to a first alignment position for alignment.
Clause 6: The system of clause 5, wherein the positioner system configured to transport the one or more donor dies to the first alignment position is configured to transport the one or more donor dies to a first inversion position, wherein on the first stage a bonding surface of the one or more donor dies faces a first direction and wherein at the first inversion position the one or more donor dies are inverted such that the bonding surface of the one or more donor dies faces a second direction substantially opposite to the first direction.
Clause 7: The system of clause 6, further comprising a flipper configured to invert the one or more donor dies at the first inversion position.
Clause 8: The system of clause 6 or clause 7, further comprising an inversion stage configured to support the one or more donor dies, wherein the one or more donor dies are supported by the inversion stage subsequent to inversion.
Clause 9: The system of clause 8, wherein the inversion stage is substantially non-moveable.
Clause 10: The system of any of clauses 5 to 9, wherein the positioner system is further configured to drive the first stage to receive the one or more donor dies at a first entry position and transport the one or more donor dies to the first measurement position subsequent to receiving the one or more donor dies.
Clause 11: The system of any preceding clause, wherein the second stage is configured to:
   support the one or more target dies at a second measurement position for measurement; and
   transport the one or more target dies to a second alignment position for alignment.
Clause 12: The system of clause 11, wherein the second alignment position is located under a first inversion position.
Clause 13: The system of any preceding clause, wherein the second stage is configured to transport the one or more donor dies and the one or more target dies after bonding to a first exit position.
Clause 14: The system of any preceding clause, wherein the measurement system is configured to measure the position of the one or more donor dies relative to the first stage.
Clause 15: The system of any of clauses 1 to 13, wherein the measurement system is configured to measure the position of the one or more donor dies relative to a first support structure, wherein the first support structure supports the one or more donor dies and wherein the first stage supports the first support structure.
Clause 16: The system of any preceding clause, wherein the measurement system is configured to measure the position of the one or more target dies relative to the second stage.
Clause 17: The system of any of clauses 1 to 15, wherein the measurement system is configured to measure the position of the one or more target dies relative to a second support structure, wherein the second support structure supports the one or more target dies and wherein the second stage supports the second support structure.
Clause 18: The system of any preceding clause, wherein the measurement system is configured to measure the position of the one or more donor dies when the first stage is located at a first measurement position and configured to measure the position of the one or more target dies when the first stage is located at a second measurement position.
Clause 19: The system of clause 18, wherein the first measurement position is the second measurement position and wherein the first stage and the second stage are moveable stages.
Clause 20: The system of any preceding clause, further comprising a flipper configured to flip an orientation of the one or more donor dies and/or the one or more target dies such that a bonding surface of the one or more donor dies faces a bonding surface of the one or more target dies.
Clause 21: The system of any preceding clause, wherein the one or more donor dies are donor dies of a donor substrate.
Clause 22: The system of clause 21, wherein the one or more donor dies are donor dies in an undiced or partially diced donor wafer.
Clause 23: The system of any preceding clause, wherein the one or more target dies are target dies of a target substrate.
Clause 24: The system of clause 23, wherein the one or more target dies are target dies in an undiced or partially diced target wafer.
Clause 25: The system of any preceding clause, further comprising an enclosure configured to receive the one or more donor dies and the one or more target dies from front opening universal pods (FOUPs).
Clause 26: The system of any preceding clause, wherein the first stage is the second stage.
Clause 27: The system of any of clauses 1 to 25, wherein the first stage and the second stage are two separate stages.
Clause 28: The system of clause 27, where the first or second stage is configured to transport a first support structure to a second exit position subsequent to die bonding of the one or more donor dies to the one or more target dies, the first support structure configured to support the one or more donor dies prior to die bonding and the first stage configured to support the first support structure.
Clause 29: The system of clause 28, wherein the first or second stage is configured to receive the first support structure from a flipper at a second inversion position.
Clause 30: The system of any preceding clause, wherein the measurement system is an optical measurement system.
Clause 31: The system of any preceding clause, further comprising a light induced forward transfer (LIFT) bonding system.
Clause 32: The system of any preceding clause, wherein the positioner system is further configured to align one or more of the one or more donor dies with corresponding one or more of the one or more target dies for die bonding by movement of the first stage and/or the second stage.
Clause 33: The system of clause 32, wherein the positioner system is further configured to align a further one of the one or more donor dies with a corresponding further one of the one or more target dies for die bonding by further movement of the first stage and/or the second stage.
Clause 34: A high-volume manufacturing tool comprising the system of any of preceding clause.
Clause 35: A method for die bonding, the method comprising:
   causing, by a processor system, a first stage to transport one or more donor dies to a measurement system, the measurement system configured to measure a position of the one or more donor dies;
   causing, by the processor system, a second stage to transport one or more target dies to the measurement system, the measurement system further configured to measure a position of the one or more target dies; and
   based on the measured position of the one or more donor dies and the measured position of the one or more target dies, aligning one or more of the one or more donor dies with corresponding one or more of the one or more target dies for die bonding.
Clause 36: The method of clause 35, further comprising bonding the one or more of the one or more donor dies to the corresponding one or more of the one or more target dies.
Clause 37: The method of clause 35 or clause 36, further comprising aligning a further one of the one or more donor dies with a corresponding further one of the one or more target dies for die bonding.
Clause 38: The method of clause 37, further comprising bonding the further one of the one or more donor dies to the corresponding further one of the one or more target dies.
Clause 39: The method of any of clauses 35 to 38, wherein aligning the one or more of the one or more donor dies with a corresponding one or more of the one or more target dies for die bonding comprises:
   causing the first stage to transport the one or more donor dies to a flipper, the flipper configured to invert the one or more donor dies and deliver the one or more donor dies to a first alignment position;
   causing the second stage to transport the one or more target dies to a second alignment position, the second alignment position being such that a bonding surface of the one or more donor dies in the first alignment position faces a bonding surface of the one or more target dies in the second alignment position; and
   activating a die transport operation, such that at least one of the one or more donor dies touches a corresponding one or more of the one or more target dies.
Clause 40: The method of clause 39, further comprising adjusting a position of the one or more donor dies in the first alignment position and/or a position of the second stage at the second alignment position to align a subsequent one of the one or more donor dies with a corresponding subsequent one of the one or more target dies, based on the measured position of the subsequent one of the one or more donor dies and the measured position of the corresponding subsequent one of the one or more target dies.
Clause 41: The method of any of clauses 35 to 40, further comprising driving the first stage and the second stage about an operational plane, the operational plane comprising an area about which the first stage and/or the second stage are moveable.
Clause 42: One or more non-transitory, machine-readable medium having instructions therein, the instructions, when executed by a processor system, configured to cause the processor system to perform at the method of any of clauses 35 to 41.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. A system for die bonding, the system comprising:
a first stage configured to support one or more donor dies;
a second stage configured to support one or more target dies;
a measurement system configured to measure a position of the one or more donor dies and configured to measure a position of the one or more target dies; and
a positioner system configured to provide relative movement between at least one of the one or more donor dies and a corresponding one of the one or more target dies for die bonding by movement of the first stage and/or the second stage.

2. The system of claim 1, wherein the positioner system is configured to drive the first stage and/or the second stage about an operational plane, the operational plane comprising an area about which the first stage and/or the second stage are moveable.

3. The system of claim 2, wherein the first stage and/or the second stage is moveable in both dimensions of the operational plane by operation of a planar motor.

4. The system of claim 1, wherein the positioner system is configured to drive the first stage to:
support the one or more donor dies at a first measurement position for measurement; and
transport the one or more donor dies to a first alignment position for alignment.

5. The system of claim 4, wherein the positioner system configured to transport the one or more donor dies to the first alignment position is configured to transport the one or more donor dies to a first inversion position, wherein on the first stage a bonding surface of the one or more donor dies faces a first direction and wherein at the first inversion position the one or more donor dies are inverted such that the bonding surface of the one or more donor dies faces a second direction substantially opposite to the first direction.

6. The system of claim 5, further comprising a flipper configured to invert the one or more donor dies at the first inversion position.

7. The system of claim 5, further comprising an inversion stage configured to support the one or more donor dies, wherein the one or more donor dies are supported by the inversion stage subsequent to inversion, and/or wherein the inversion stage is substantially non-moveable.

8. The system of claim 4, wherein the positioner system is further configured to drive the first stage to receive the one or more donor dies at a first entry position and transport the one or more donor dies to the first measurement position subsequent to receiving the one or more donor dies, and wherein the second stage is configured to:
support the one or more target dies at a second measurement position for measurement; and
transport the one or more target dies to a second alignment position for alignment.

9. The system of claim 1, wherein the second stage is configured to transport the one or more donor dies and the one or more target dies after bonding to a first exit position.

10. The system of claim 1, wherein the measurement system is configured to measure the position of the one or more donor dies relative to a first support structure, wherein the first support structure supports the one or more donor dies and wherein the first stage supports the first support structure.

11. The system of claim 1, wherein the measurement system is configured to measure the position of the one or more target dies relative to the second stage, and/or wherein the measurement system is configured to measure the position of the one or more target dies relative to a second support structure, wherein the second support structure supports the one or more target dies and wherein the second stage supports the second support structure.

12. The system of claim 1, further comprising a flipper configured to flip an orientation of the one or more donor dies and/or the one or more target dies such that a bonding surface of the one or more donor dies faces a bonding surface of the one or more target dies.

13. The system of claim 12, wherein the one or more target dies are target dies in an undiced or partially diced target wafer.

14. The system of any preceding claim, further comprising a light induced forward transfer (LIFT) bonding system.

15. A method for die bonding, the method comprising:
causing, by a processor system, a first stage to transport one or more donor dies to a measurement system, the measurement system configured to measure a position of the one or more donor dies;
causing, by the processor system, a second stage to transport one or more target dies to the measurement system, the measurement system further configured to measure a position of the one or more target dies; and
based on the measured position of the one or more donor dies and the measured position of the one or more target dies, aligning one or more of the one or more donor dies with corresponding one or more of the one or more target dies for die bonding.
